# EUROPEAN PATENT APPLICATION

(11) **EP 4 791 165 A1**
(43) Date of publication of application: **12.08.2026**
(21) Application number: 24875044.0
(22) Date of filing: 27.09.2024
(51) Int. Cl.: H10K 59/80, H10K 59/131, H10K 59/12, H10K 71/00, H10K 71/60

(54) **ORGANIC LIGHT-EMITTING DISPLAY DEVICE**

(30) Priority: 06.10.2023 KR 20230133720; 26.09.2024 KR 20240130540
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/096228
(87) International publication number: WO 2025/075489

(57) **Abstract**

The organic light-emitting display device may include a plurality of anode electrodes in a plurality of subpixels, a plurality of organic light-emitting layers on the plurality of anode electrodes, a plurality of cathode electrodes on the plurality of organic light-emitting layers, a plurality of first banks between the plurality of subpixels in a second direction crossing a first direction, a plurality of first power wirings along the first direction under the plurality of first banks, and a plurality of connection structures disposed in a plurality of first grooves of some of the first banks among the plurality of first banks. The organic light-emitting layers and the cathode electrodes may be disposed across the some of the first banks, and the connection structures may electrically connect the cathode electrodes in the first grooves of the some of the first banks to the first power wirings.

## Description

### [Technical Field]

The embodiment relates to an organic light-emitting display device.

### [Background Art]

As the demand for portable information media increases, attempts to apply an organic light-emitting display device to various lightweight and thin information electronic devices are expanding. Recently, the organic light-emitting display device is being applied to product groups such as a mobile PC and an automobile rather than a TV or a mobile phone. Since the organic light-emitting display device applied to the mobile PC or the automobile is driven as a still image for a long time, long lifespan is required. In order to have the long lifespan, the extraction of light from the organic light-emitting element equipped in the organic light-emitting display device should be maximized. In addition, in order to reduce cost, it is necessary to expand the technology to enable the production of organic light-emitting elements on substrates of not only 8.5 generation (2200x2,500mm) but also 10.5 generation (3370x2940mm). In order to produce long-lifespan organic light-emitting elements, each subpixel with a top emission structure and a side-by-side structure must be implemented as a structure of an organic light-emitting element of two or more stacks.

The structure of such an organic light-emitting element can be obtained through a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low PPA (pixel position accuracy) between the FMM and the substrate in a subpixel unit. Accordingly, the emission area ratio (EAR) is small, which limits the product life. Here, EAR is the value obtained by dividing the emission area of a subpixel by the total area of the subpixel.

Therefore, the development of a new deposition method to solve the aforementioned problems and an organic light-emitting display device having a structure of a new organic light-emitting element using the new deposition method is very urgent.

### [Disclosure]

### [Technical Problem]

An object of the embodiment is to solve the foregoing and other problems.

Another object of the embodiment is to provide an organic light-emitting display device having a novel structure.

Another object of the embodiment is to provide an organic light-emitting display device capable of improving the lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that can be understood through the description of the invention.

### [Technical Solution]

According to one aspect of the embodiment to achieve the above or other objects, an organic light-emitting display device, comprising: a plurality of subpixels having different colors along a first direction and having the same color along a second direction crossing the first direction; a plurality of anode electrodes in the plurality of subpixels; a plurality of organic light-emitting layers on the plurality of anode electrodes; a plurality of cathode electrodes on the plurality of organic light-emitting layers; a plurality of first banks between the plurality of subpixels along the second direction; a plurality of first power wirings along the first direction under the plurality of first banks; and a plurality of connection structures disposed in a plurality of first grooves of some of the first banks among the plurality of first banks, wherein the organic light-emitting layer and the cathode electrode are disposed across the some of the first banks, and wherein the connection structure is configured to electrically connect the cathode electrode to the first power wiring in the first groove of the some of the first banks.

The connection structure may comprise a lower electrode extended from the first power wiring; and an upper electrode on the lower electrode, and the cathode electrode may be in contact with an upper surface of the upper electrode.

The upper electrode may comprise the same material as the anode electrode.

The connection structure may comprise an auxiliary electrode extended from the first power wiring; and a connection part penetrating the organic light-emitting layer on the auxiliary electrode, and the cathode electrode may be in contact with some regions of the auxiliary electrode through the connection part.

The cathode electrode may comprise a first conductive layer; and a second conductive layer on the first conductive layer, and the connection part may comprise the same material as the first conductive layer.

The organic light-emitting display device may further comprise an open structure in an edge region of the first bank, and a hole injection layer or a charge generation layer of the organic light-emitting layer is disconnected by the open structure.

The organic light-emitting display device may comprise a plurality of inorganic insulating layers on the plurality of cathode electrodes; a plurality of second banks disposed lengthwise along the second direction between the plurality of subpixels in the first direction; and a plurality of waterproof structures in each of the plurality of second banks.

The plurality of waterproof structures may comprise a first waterproof structure on the second bank; a second waterproof structure on a first side of a second groove of the second bank; and a third waterproof structure on a second side of the second groove of the second bank.

The first waterproof structure may be configured such that at least two or more inorganic insulating layers among the plurality of inorganic insulating layers are overlapped on the second bank.

An uppermost layer among the at least two or more inorganic insulating layers may be an island insulating pattern.

The second waterproof structure may be configured such that one inorganic insulating layer among the plurality of inorganic insulating layers is formed in a curved shape by a first undercut structure, the third waterproof structure may be configured such that another inorganic insulating layer among the plurality of inorganic insulating layers is formed in a curved shape by a second undercut structure, and the first undercut structure and the second undercut structure are formed on a lower side of the second bank that contacts the second groove of the second bank.

The organic light-emitting display device may further comprise a plurality of organic insulating layers on the plurality of inorganic insulating layers, and one inorganic insulating layer among the plurality of inorganic insulating layers may be disposed between two organic insulating layers among the plurality of organic insulating layers in the second groove.

The one inorganic insulating layer may have a round surface.

The organic light-emitting display device may further comprise a plurality of second power wirings along the second direction in the plurality of second grooves of the plurality of second banks, the plurality of second power wirings may be configured to be electrically connected to the plurality of first power wirings, and the at least two or more inorganic insulating layers may be disposed on the second power wirings.

The organic light-emitting display device may further comprise a plurality of dummy subpixels having a stripe shape along the first direction in a non-display region; and a plurality of waterproof structures between the plurality of dummy subpixels in the second direction.

### [Advantageous Effects]

The effects of the organic light-emitting display device according to the embodiment are described as follows.

According to at least one of the embodiments, since there is no need to use an FMM, the process can be simplified and the process cost can be reduced.

According to at least one of the embodiments, since there is no need to use an FMM, the EAR in the subpixel can be increased, and the lifespan can be improved.

According to at least one of the embodiments, an organic light-emitting element is deposited on a large-area substrate in an in-line deposition system, so that productivity, yield, and material utilization efficiency can be improved.

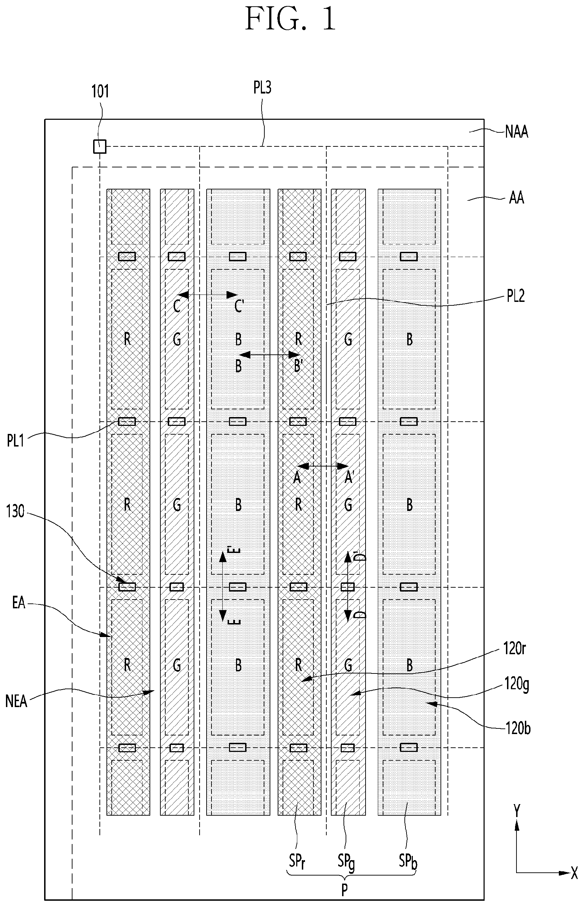

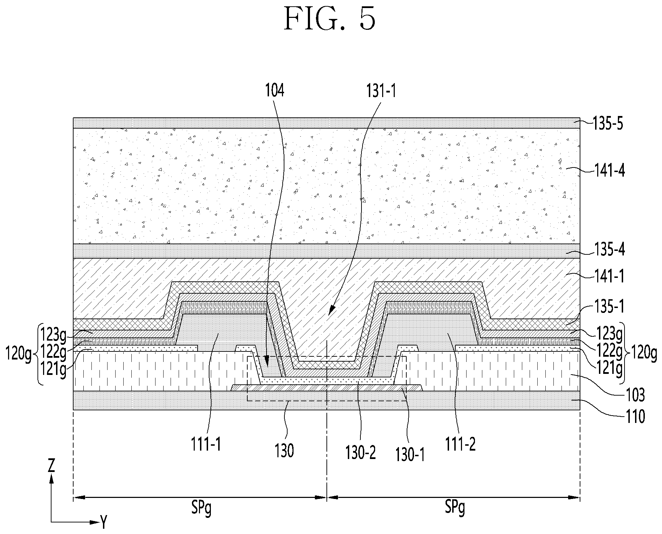

According to at least one of the embodiments, as illustrated in FIGS. 1 and 5, a connection structure 130 may be disposed in a first groove 131-1 of a plurality of first banks 111-1 between a plurality of subpixels SPr, SPg, and SPb having the same color along the second direction Y, so that electrical connection between cathode electrodes 123r, 123g, and 123b of the plurality of subpixels SPr, SPg, and SPb and the first power wiring PL1 can be facilitated and a short-circuit defect can be prevented. Thus, operation failure or light-emission failure of the sub-pixels SPr, SPg and SPb can be prevented, thereby improving reliability. In particular, a plurality of subpixels SPr, SPg, and SPb may be grouped along the second direction Y and a connection structure 130 may be disposed between the grouped subpixels, so that the number of shots of the laser beam can be drastically reduced when using the laser ablation process to be described later, thereby reducing the process time or process cost.

According to at least one of the embodiments, as illustrated in FIGS. 1 to 4, a plurality of waterproof structures 143, 144-1 to 144-3, and 145-1 to 145-3 may be disposed in each of the plurality of second banks 111-2, so that moisture, oxygen, etc. penetrating along the second direction Y do not penetrate into the plurality of subpixels SPr, SPg, and SPb, so that reliability can be improved by preventing malfunctions in operation or light-emission of subpixels SPr, SPg, and SPb.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view schematically illustrating an organic light-emitting display device according to a first embodiment.
FIG. 2 is a cross-sectional view illustrating an organic light-emitting display device according to a first embodiment.
FIG. 3 is a cross-sectional view illustrating an organic light-emitting display device according to a second embodiment.
FIG. 4 is a cross-sectional view illustrating an organic light-emitting display device according to a third embodiment.
FIG. 5 is a cross-sectional view illustrating an organic light-emitting display device according to a fourth embodiment.
FIG. 6 is a cross-sectional view illustrating an organic light-emitting display device according to a fifth embodiment.
FIGS. 7A to 7R illustrate a manufacturing process of an organic light-emitting display device along line A-A' of FIG. 1.
FIGS. 8A to 8R illustrate a manufacturing process of an organic light-emitting display device along the D-D' line of FIG. 1.
FIG. 9 is a cross-sectional view illustrating an organic light-emitting display device according to a sixth embodiment.
FIGS. 10A to 10C illustrate a manufacturing process of an organic light-emitting display device according to the sixth embodiment.
FIG. 11 is a cross-sectional view illustrating an organic light-emitting display device according to a seventh embodiment.
FIG. 12 is a cross-sectional view illustrating an organic light-emitting display device according to an eighth embodiment.
FIG. 13 is a cross-sectional view illustrating an organic light-emitting display device according to a ninth embodiment.
FIG. 14 is a cross-sectional view illustrating an organic light-emitting display device according to a tenth embodiment.
FIG. 15 is a plan view schematically illustrating an organic light-emitting display device according to a second embodiment.
FIG. 16 is a cross-sectional view illustrating an organic light-emitting display device according to an eleventh embodiment.

The sizes, shapes, dimensions, etc. of elements illustrated in the drawings can differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

Hereinafter, an organic light-emitting display device having a side-by-side structure manufactured using a photolithography process is disclosed. This structure is called Ph-SbS (side-by-side structure by photolithography). By using a photolithography process, there is no need to use an FMM, so that the process can be simplified and the process cost can be reduced. In addition, the EAR within the subpixel may be increased, so that the lifespan can be improved. In addition, since the organic light-emitting element is deposited on a large-area substrate in an in-line deposition system, productivity, yield, and material utilization efficiency can be improved.

Hereinafter, a red subpixel may be named a first subpixel, a green subpixel may be named a second subpixel, and a blue subpixel may be named a third subpixel. In addition, a red organic light-emitting element may be named a first organic light-emitting element, a green organic light-emitting element may be named a second organic light-emitting element, and a blue organic light-emitting element may be named a third organic light-emitting element.

Hereinafter, the organic light-emitting display device is a top emission type that displays an image by emitting light in an upper direction of the substrate, but a bottom emission type that displays an image by emitting light in a lower direction of the substrate may also be included in the technical idea of the present invention.

FIG. 1 is a plan view schematically illustrating an organic light-emitting display device according to a first embodiment.

As illustrated in FIG. 1, the organic light-emitting display device according to the first embodiment may comprise a plurality of pixels P arranged in a matrix. The plurality of pixels P may be positioned in a display region AA. The remaining region excluding the display region AA may be a non-display region NAA.

The plurality of subpixels SPr, SPg, and SPb may have different colors along the first direction X and may have the same color along the second direction Y crossing the first direction X.

The plurality of pixels P may comprise, for example, a plurality of red subpixels SPr, a plurality of green subpixels SPg, a plurality of blue subpixels SPb, etc.

A plurality of red subpixels SPr, a plurality of green subpixels SPg, and a plurality of blue subpixels SPb may be alternately arranged in a column-line unit along a first direction X. The red subpixels SPr, the green subpixels SPg, and the blue subpixels SPb may be sequentially positioned along the first direction X, so that an organic light-emitting display device having a side-by-side structure may be implemented.

A plurality of red subpixels SPr may be arranged in a stripe shape along a second direction Y. A plurality of green subpixels SPg may be d arranged in a stripe shape along the second direction Y. A plurality of blue subpixels SPb may be arranged in a stripe shape along the second direction Y.

For example, a red organic light-emitting element 120r may be disposed in a red subpixel SPr, a green organic light-emitting element 120g may be disposed in a green subpixel SPg, and a blue organic light-emitting element 120b may be disposed in a blue subpixel SPb.

It is illustrated that a pixel P as comprising three subpixels SPr, SPg, and SPb in the drawing, but more subpixels may be included than these. It is illustrated that the area of the blue subpixel SPb is greater than the area of the red subpixel SPr or the area of the green subpixel SPg in the drawing, but other variations are possible.

Each subpixel SPr, SPg, and SPb may comprise an emission region EA and a non-emission region NEA. The emission region EA may be a region where the organic light-emitting elements 120r, 120g, and 120b of the subpixels SPr, SPg, and SPb are disposed, and the non-emission region NEA may be the remaining region excluding the emission region EA in each subpixel SPr, SPg, and SPb.

The red organic light-emitting element 120r, the green organic light-emitting element 120g, and the blue organic light-emitting element 120b may each comprise an anode electrode, an organic light-emitting layer, and a cathode electrode. The organic light-emitting layer may comprise a hole injection layer, a hole transport layer, an organic emission layer, an electron transport layer, an electron injection layer, a charge generation layer, etc. The red organic light-emitting element 120r, the green organic light-emitting element 120g, and the blue organic light-emitting element 120b may each comprise at least two or more stack structures. An organic emission layer that emits light may be included in each stack structure.

The organic light-emitting layer and the cathode electrode may each be disposed across the plurality of red subpixels SPr along the second direction Y. In other words, the organic light-emitting layer and the cathode electrode may each be disposed continuously without being separated along the second direction Y.

In contrast, the anode electrode may be disposed only within the plurality of red subpixels SPr along the second direction Y. That is, the anode electrode may not be disposed between the plurality of red subpixels SPr along the second direction Y. In addition, the organic light-emitting layer and the cathode electrode may be disposed across the plurality of green subpixels SPg along the second direction Y, respectively, and the anode electrode may be disposed only within each green subpixel SPg along the second direction Y. The organic light-emitting layer and the cathode electrode may be disposed across the plurality of blue subpixels SPb along the second direction Y, respectively, and the anode electrode may be disposed only within each blue subpixel SPb along the second direction Y. Accordingly, the emission region EA within each subpixel SPr, SPg, and SPb may be distinguished by the anode electrode provided in each subpixel SPr, SPg, and SPb.

Although not illustrated, the organic light-emitting layer and the cathode electrode may be separated into at least two or more subpixel units or two or more row-line units, respectively.

Meanwhile, power wirings PL1 to PL3 may be provided to supply power to a plurality of subpixels SPr, SPg, and SPb. A power terminal 101 may be electrically connected to one end of a third power wiring PL3. The power terminal 101 may be electrically connected to a power supply unit (not illustrated) to receive a first potential voltage. Although not illustrated, another power wiring may be provided to supply a second potential voltage greater than the first potential voltage.

The power wirings PL1 to PL3 may be disposed in a non-display region NAA and a display region AA. The first and second power wirings PL1 and PL2 may be disposed between the plurality of subpixels SPr, SPg, and SPb in the display region AA to be electrically connected to the plurality of subpixels SPr, SPg, and SPb. The first and second power wirings PL1 and PL2 may be electrically connected to the plurality of cathode electrodes 123r, 123g and 123b of the plurality of organic light-emitting elements 120r, 120g and 120b provided in the plurality of subpixels SPr, SPg and SPb. The third power wiring PL3 may electrically connect the power terminal 101 and the second power wiring PL2 in the non-display region NAA.

Meanwhile, the plurality of subpixels SPr, SPg and SPb may each comprise a driving circuit, for example, a driving transistor. Another power wiring may be electrically connected to the driving transistor of each of the subpixels SPr, SPg and SPb, but is not limited thereto. Accordingly, when a specific subpixel is selected in response to a scan signal provided through a specific gate line, light having a luminance corresponding to a current flowing in a driving transistor of a specific subpixel may be emitted using a first potential voltage provided through the power wirings PL1 to PL3 and a second potential voltage provided through another power wiring.

Meanwhile, a plurality of connection structures 130, a plurality of waterproof structures, a plurality of open structures, etc. may be disposed between a plurality of subpixels SPr, SPg, and SPb.

The connection structure 130 may be a structure that electrically connects the second power wiring PL2 to the cathode electrode of each of the organic light-emitting elements 120r, 120g, and 120b.

The open structure may be a structure that separates layers comprising low-resistance organic light-emitting materials of each of the organic light-emitting elements 120r, 120g, and 120b, such as a hole injection layer, a charge generation layer, etc., thereby preventing electrical shorts between the anode electrode and the cathode electrode and reducing leakage current between the subpixels.

As will be explained later, the transverse leakage current or the longitudinal leakage current between the plurality of subpixels SPr, SPg, and SPb can be prevented by the open structure. The transverse leakage current may be a leakage current that flows between adjacent subpixels SPr, SPg, and SPb along the first direction X, and the longitudinal leakage current may be a leakage current that flows between adjacent subpixels SPr, SPg, and SPb along the second direction Y. In addition, an electrical short between the anode electrode and the cathode electrode in the corresponding subpixels SPr, SPg, and SPb can be prevented by the open structure. Therefore, by using the open structure, color spot due to leakage current can be improved and luminance can be significantly improved.

Meanwhile, the waterproof structure may be positioned in the non-emission region NEA. The waterproof structure can prevent moisture, oxygen, etc. from penetrating into the non-display region NAA or the display region AA.

As will be explained later, the waterproof structure may be disposed lengthwise along the second direction Y between a plurality of subpixels SPr, SPg, and SPb on the first direction X.

Since moisture, oxygen, etc. flowing from the non-display region NAA to the display region AA by using the waterproof structure do not penetrate into each subpixel SPr, SPg, and SPb, the organic light-emitting layer of each subpixel SPr, SPg, and SPb is not affected by moisture, oxygen, etc., and reliability can be dramatically improved. In other words, the organic light-emitting layer is vulnerable to moisture, oxygen, etc., and when the organic light-emitting layer is damaged by moisture, oxygen, etc., the corresponding subpixel SPr, SPg, and SPb may not operate, resulting in a light-emission failure. When many subpixels SPr, SPg, and SPb do not operate due to moisture, oxygen, etc., display failures such as point light-emission failure or region light-emission failure may occur, which may lower product reliability.

However, since the penetration of moisture, oxygen, etc. is fundamentally blocked by a waterproof structure such as the embodiment, reliability can be improved.

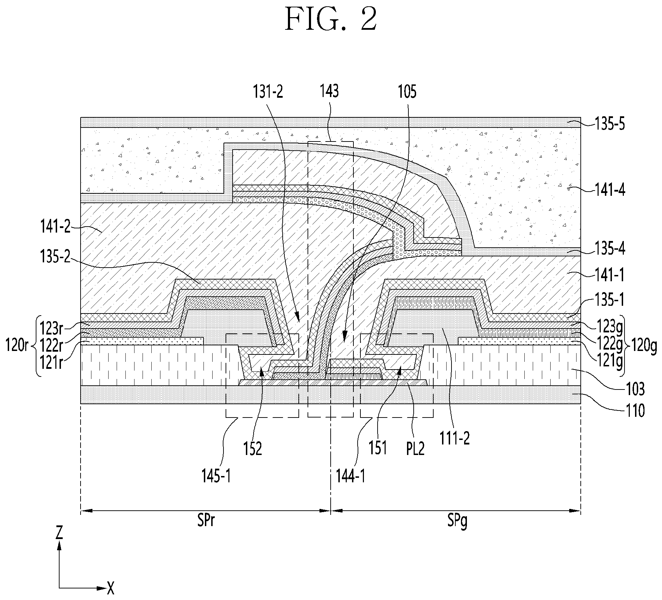

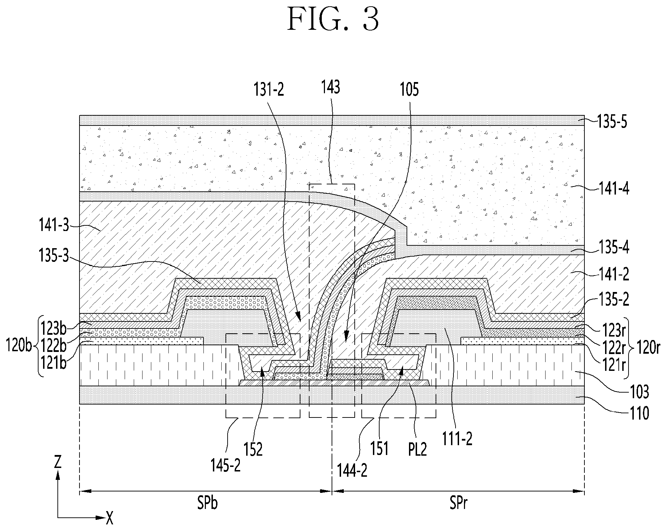

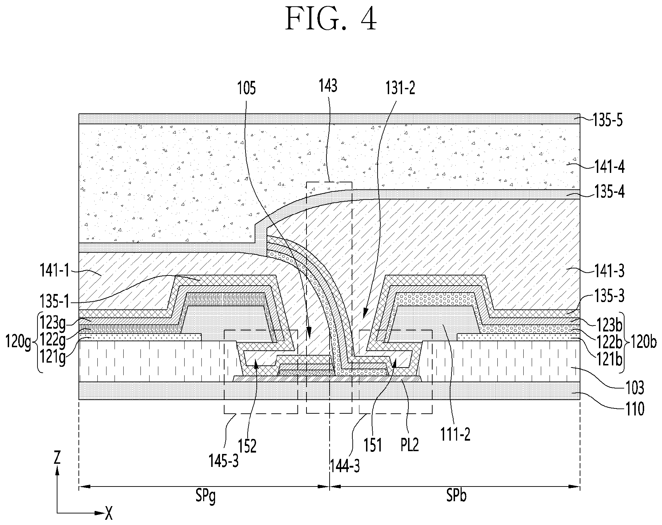

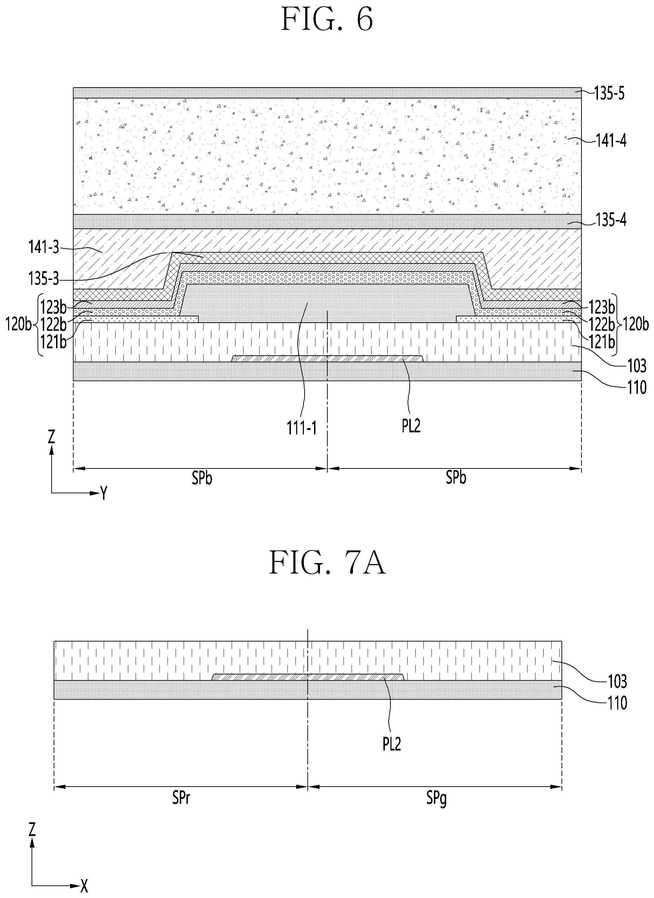

FIG. 2 is a cross-sectional view illustrating an organic light-emitting display device according to a first embodiment. FIG. 3 is a cross-sectional view illustrating an organic light-emitting display device according to a second embodiment. FIG. 4 is a cross-sectional view illustrating an organic light-emitting display device according to a third embodiment. FIG. 5 is a cross-sectional view illustrating an organic light-emitting display device according to a fourth embodiment. FIG. 6 is a cross-sectional view illustrating an organic light-emitting display device according to a fifth embodiment. FIGS. 2 to 6 are cross-sectional views taken along lines A-A', B-B', C-C', D-D', and E-E' in FIG. 1, respectively.

Referring to FIGS. 1 to 6, an organic light-emitting display device according to an embodiment may comprise a plurality of banks 111-1 and 111-2, a plurality of power wirings PL1 to PL3, a plurality of organic light-emitting elements 120r, 120g, and 120b, a plurality of connection structures 130, etc.

A plurality of banks 111-1 and 111-2, a plurality of power wirings PL1 to PL3, a plurality of organic light-emitting elements 120r, 120g, and 120b, and a plurality of connection structures 130 may be disposed on a substrate 110.

An interlayer-insulating layer 103 may be disposed on the substrate 110, and a plurality of banks 111-1 and 111-2, a plurality of organic light-emitting elements 120r, 120g, and 120b, and a plurality of connection structures 130 may be disposed on the interlayer-insulating layer 103.

A plurality of driving circuits may be formed on the substrate 110. The plurality of driving circuits may be provided in the plurality of subpixels SPr, SPg, and SPb, respectively. The plurality of driving circuits may comprise a plurality of transistors, at least one or more capacitor, etc. The plurality of transistors may comprise a scan transistor, a driving transistor, a sensing transistor, etc.

An interlayer-insulating layer 103 may be disposed on the plurality of driving circuits. The interlayer-insulating layer 103 may be a planarization layer. To this end, an upper surface of the interlayer-insulating layer 103 may have a flat surface.

Meanwhile, a plurality of power wirings PL1 to PL3 may be disposed on the substrate 110. The plurality of power wirings may comprise a plurality of first power wirings PL1, a plurality of second power wirings PL2, a third power wiring PL3, etc. The plurality of first power wirings PL1 and the plurality of second power wirings PL2 may be disposed on the display region AA, and the third power wiringsPL3 may be disposed on the non-display region NAA.

The third power wiring PL3 may be electrically connected to the power terminal 101. The first power wiring PL1 and the second power wiring PL2 may electrically connect the third power wiring PL3 to a plurality of subpixels SPr, SPg, and SPb on the display region AA.

The third power wiring PL3 may be disposed on a different layer from the first power wiring PL1 and the second power wiring PL2. The first power wiring PL1 and the second power wiring PL2 may be disposed on the same layer, but is not limited thereto.

The first power wiring PL1 and the second power wiring PL2 may be electrically connected to the third power wiring PL3 using a contact pad. For example, the second power wiring PL2 may be disposed to extend from the display region AA to the non-display region NAA, and may be electrically connected to the third power wiring PL3 using a contact pad in the non-display region NAA. The contact pad may be provided in the display region AA or the non-display region NAA.

For example, the first power wiring PL1 and the second power wiring PL2 may be formed together with a source electrode and a drain electrode of the driving transistor. That is, the source electrode and the drain electrode of the driving transistor and the first power wiring PL1 and the second power wiring PL2 may be formed on the same layer with the same material by using the same process.

For example, the third power wiring PL3 may be formed together with the cathode electrodes 123r, 123g, and 123b. That is, the cathode electrodes 123r, 123g, and 123b and the third power wiring PL3 may be formed on the same layer with the same material by using the same process.

Meanwhile, a plurality of first power wirings PL1 may be disposed between a plurality of subpixels SPr, SPg, and SPb on the second direction Y, and a plurality of second power wirings PL2 may be disposed between a plurality of subpixels SPr, SPg, and SPb on the first direction X. The plurality of first power wirings PL1 may be disposed lengthwise along the first direction X between the plurality of subpixels SPr, SPg, and SPb on the second direction Y, and the plurality of second power wirings PL2 may be disposed lengthwise along the second direction Y between the plurality of subpixels SPr, SPg, and SPb on the first direction X.

The plurality of first power wirings PL1 and the plurality of second power wirings PL2 may intersect and be connected to each other. The plurality of first power wirings PL1 and the plurality of second power wirings PL2 may have a matrix structure.

The plurality of banks may comprise a plurality of first banks 111-1 and a plurality of second banks 111-2. The first banks 111-1 and the second banks 111-2 may intersect and be connected to each other. The plurality of first banks 111-1 and the plurality of second banks 111-2 may have a matrix structure.

The plurality of first banks 111-1 may be disposed to correspond to the plurality of first power wirings PL1, and the plurality of second banks 111-2 may be disposed to correspond to the plurality of second power wiring PL2. That is, the plurality of first banks 111-1 may be disposed on the plurality of first power wirings PL1, and the plurality of second banks 111-2 may be disposed on the plurality of second power wiring PL2.

The plurality of first banks 111-1 may be disposed between the plurality of subpixels SPr, SPg, and SPb on the second direction Y, and the plurality of second banks 111-2 may be disposed between the plurality of subpixels SPr, SPg, and SPb on the first direction X. The plurality of first banks 111-1 may be disposed lengthwise along the first direction X between the plurality of subpixels SPr, SPg, and SPb on the second direction Y, and the plurality of second banks 111-2 may be disposed lengthwise along the second direction Y between the plurality of subpixels SPr, SPg, and SPb on the first direction X.

As an example, the plurality of emission regions EA may be separated by the plurality of first banks 111-1 and the plurality of second banks 111-2. The plurality of emission regions EA may be surrounded by the plurality of first banks 111-1 and the plurality of second banks 111-2.

As another example, the plurality of emission regions EA may be separated by the plurality of anode electrodes 121r, 121g, and 121b individually provided on the plurality of subpixels SPr, SPg, and SPb. The plurality of anode electrodes 121r, 121g, and 121b may be disposed only within the plurality of subpixels SPr, SPg, and SPb, and may be not disposed between the plurality of subpixels SPr, SPg, and SPb.

As another example, the emission region EA may be defined by the organic light-emitting layers 122r, 122g, and 122b exposed by the first bank 111-1 and the second bank 111-2. Since the organic light-emitting layers 122r, 122g, and 122b emit light in an area equal to that of the exposed organic light-emitting layers 122r, 122g, and 122b, the emission region EA exposed by the first bank 111-1 and the second bank 111-2 may be defined.

The plurality of subpixels SPr, SPg, and SPb may each comprise an emission region EA and a non-light-emission region NEA. The regions corresponding to the banks 111-1 and 111-2 may be defined as non-emitting regions NEA. In this instance, the banks 111-1 and 111-2 may be shared by the adjacent subpixels SPr, SPg and SPb. That is, a part of the banks 111-1 and 111-2 may be included in one subpixel, and another part of the banks 111-1 and 111-2 may be included in another subpixel adjacent to one subpixel.

The plurality of organic light-emitting elements 120r, 120g and 120b may be disposed in the plurality of subpixels SPr, SPg and SPb, respectively. The plurality of organic light-emitting elements 120r, 120g and 120b may comprise the plurality of anode electrodes 121r, 121g and 121b, the plurality of organic light-emitting layers 122r, 122g and 122b and the plurality of cathode electrodes 123r, 123g and 123b.

The anode electrodes 121r, 121g and 121b may be disposed only in the respective subpixels SPr, SPg and SPb along the first direction X and the second direction Y. The red anode electrode 121r may be disposed only on the plurality of red subpixels SPr along the second direction Y, the green anode electrode 121g may be disposed only on the plurality of green subpixels SPg along the second direction Y, and the blue anode electrode 121b may be disposed only on the plurality of blue subpixels SPb along the second direction Y.

The organic light-emitting layers 122r, 122g, and 122b may be separated from each other along the first direction X but may be disposed continuously along the second direction Y. The red organic light-emitting layer 122r may be disposed continuously on the plurality of red subpixels SPr as well as the plurality of first banks 111-1 along the second direction Y. The green organic light-emitting layer 122g may be disposed continuously on the plurality of green subpixels SPg as well as the plurality of first banks 111-1 along the second direction Y. The blue organic light-emitting layer 122b may be disposed continuously on the plurality of subpixels SPr, SPg, and SPb as well as the plurality of first banks 111-1 along the second direction Y. The red organic light-emitting layer 122r, the green organic light-emitting layer 122g, and the blue organic light-emitting layer 122b may be referred to as the first organic light-emitting layer, the second organic light-emitting layer, and the third organic light-emitting layer, respectively.

The cathode electrodes 123r, 123g, and 123b may be disposed continuously along the second direction Y, while being separated from each other along the first direction X. The red cathode electrode 123r may be disposed continuously on the plurality of subpixels SPr, SPg, and SPb as well as the plurality of first banks 111-1 along the second direction Y. The green cathode electrode 123g may be disposed continuously on the plurality of green subpixels SPg as well as the plurality of first banks 111-1 along the second direction Y. The blue cathode electrode 123b may be disposed continuously on the plurality of subpixels SPr, SPg, and SPb as well as the plurality of first banks 111-1 along the second direction Y. The red cathode electrode 123r, the green cathode electrode 123g, and the blue cathode electrode 123b may be referred to as the first cathode electrode, the second cathode electrode, and the third cathode electrode, respectively.

The plurality of connection structures 130 may be disposed in the plurality of first banks 111-1. Although it is illustrated that the connection structures 130 are disposed in all of the plurality of first banks 111-1 in the drawing, it may not be disposed in all of the plurality of first banks 111-1. That is, the connection structures 130 may be disposed in some of the first banks 111-1 among the plurality of first banks 111-1.

The plurality of first banks 111-1 may have a plurality of first grooves 131-1. The first grooves 131-1 may be locally formed in some regions of the first bank 111-1 between the plurality of subpixels SPr, SPg, and SPb on the second direction Y. The first groove 131-1 may have a circular or rectangular shape when viewed from above, but is not limited thereto. The first groove 131-1 may be formed by penetrating from the upper surface to the lower surface at a center part of the first bank 111-1, but is not limited thereto.

As illustrated in FIG. 5, the connection structure 130 may be disposed in the first groove 131-1 of the first bank 111-1. The connection structure 130 may electrically connect the green cathode electrode 123g to the first power wiring PL1 in the first groove 131-1 of the first bank 111-1.

The connection structure 130 may comprise a lower electrode 130-1 and an upper electrode 130-2.

The lower electrode 130-1 may be formed by extending from the first power wiring PL1. Among the first power wiring PL1 disposed lengthwise along the first direction X, the first power wiring PL1 corresponding to the first groove 131-1 of the first bank 111-1 may be formed as the lower electrode 130-1. Accordingly, the lower electrode 130-1 may be a part of the first power wiring PL1. The width of the lower electrode 130-1 may be greater than the width of the first power wiring PL1, but is not limited thereto.

The upper electrode 130-2 may be disposed on the lower electrode 130-1. A lower surface of the upper electrode 130-2 may be in contact with an upper surface of the lower electrode 130-1. The upper electrode 130-2 may comprise the same material as the green anode electrode 121g.

The green cathode electrode 123g may be electrically connected to the first power wiring PL1 through the connection structure 130. To this end, the green cathode electrode 123g may be in contact with the upper surface of the upper electrode 130-2 of the connection structure 130.

A first groove 104 may also be formed in the interlayer-insulating layer 103 corresponding to the first groove 131-1 of the first bank 111-1. The lower electrode 130-1 may be exposed by the first groove 104 of the interlayer-insulating layer 103, and the upper electrode 130-2 may be disposed on the exposed lower electrode 130-1. In addition, the upper electrode 130-2 may be exposed by the first groove 131-1 of the first bank 111-1, and the green cathode electrode 123g may be disposed on the exposed upper electrode 130-2.

After the green organic light-emitting layer 122g is deposited on the upper electrode 130-2, the green organic light-emitting layer 122g may be removed to expose the upper electrode 130-2, and the green cathode electrode 123g may be formed on the exposed upper electrode 130-2. When the green organic light-emitting layer 122g is not completely removed, the unremoved particles, i.e., residual particles or lumps, of the green organic light-emitting layer 122g may be disposed on the upper surface of the upper electrode 130-2. In this instance, the green cathode electrode 123g may be in contact with the upper surface of the upper electrode 130-2 of the connection structure 130 through the residual particles or lumps.

Meanwhile, as illustrated in FIG. 1 and FIG. 6, the first grooves 131-1 and 104 may be not formed in the remaining region except for the connection structure 130 between the plurality of blue subpixels SPb in the second direction Y. That is, since the first grooves 131-1 and 104 are not formed in the interlayer-insulating layer 103 and the first bank 111-1, an upper surface of the interlayer-insulating layer 103 and an upper surface of the first bank 111-1 may have a flat surface. Accordingly, the green organic light-emitting layer 122g, the green cathode electrode 123g, etc. on the first bank 111-1 may be formed to be connected to the adjacent green subpixel SPg without a break.

Meanwhile, a plurality of second banks 111-2 may be disposed between a plurality of subpixels SPr, SPg, and SPb on the first direction X. The plurality of second banks 111-2 may be disposed lengthwise along the second direction Y. A plurality of second grooves 131-2 may be formed in the plurality of second banks 111-2. The plurality of second grooves 131-2 may be formed lengthwise along the second direction Y. The second grooves 131-2 may be formed to penetrate from an upper surface to a lower surface at a center part of the second bank 111-2, but are not limited thereto.

The second groove 105 may be formed in the interlayer-insulating layer 103 corresponding to the second groove 131-2 of the second bank 111-2. The second power wiring PL2 may be exposed by the second groove 105 of the interlayer-insulating layer 103.

Meanwhile, as illustrated in FIGS. 2 to 4, the organic light-emitting display device according to the embodiment may comprise a plurality of inorganic insulating layers 135-1 to 135-5, a plurality of organic insulating layers 141-1 to 141-4, a plurality of waterproof structures 143, 144-1 to 144-3, and 145-1 to 145-3, etc.

The plurality of inorganic insulating layers may comprise a first inorganic insulating layer 135-1, a second inorganic insulating layer 135-2, a third inorganic insulating layer 135-3, a fourth inorganic insulating layer 135-4, and a fifth inorganic insulating layer 135-5. The first inorganic insulating layer 135-1, the second inorganic insulating layer 135-2, the third inorganic insulating layer 135-3, the fourth inorganic insulating layer 135-4, and the fifth inorganic insulating layer 135-5 may each comprise at least one or more inorganic insulating film.

The first inorganic insulating layer 135-1 may be disposed on the green cathode electrode 123g of the green organic light-emitting element 120g in the green subpixel SPg, the second inorganic insulating layer 135-2 may be disposed on the red cathode electrode 123r of the red organic light-emitting element 120r in the red subpixel SPr, and the third inorganic insulating layer 135-3 may be disposed on the blue cathode electrode 123b of the blue organic light-emitting element 120b in the blue subpixel SPb.

The first inorganic insulating layer 135-1, the second inorganic insulating layer 135-2, and the third inorganic insulating layer 135-3 may each be configured as a double layer comprising a silicon oxide layer and a silicon nitride layer. The silicon nitride layer may be disposed on the silicon oxide layer. For example, the silicon oxide layer may be formed using an atomic layer deposition (ALD) process, and the silicon nitride layer may be formed using a chemical vapor deposition (CVD) process.

The fourth inorganic insulating layer 135-4 and the fifth inorganic insulating layer 135-5 may be formed on the entire region of the substrate 110. The fourth inorganic insulating layer 135-4 and the fifth inorganic insulating layer 135-5 may be formed using a PECVD process as a silicon nitride series, but is not limited thereto. At least one or more of the fourth inorganic insulating layer 135-4 and the fifth inorganic insulating layer 135-5 may be omitted.

Therefore, by disposing the plurality of inorganic insulating layers 135-1 to 135-5 in each of the plurality of subpixels SPr, SPg and SPb or in the entire region of the substrate 110, penetration of moisture, oxygen, etc. can be completely blocked.

The plurality of organic insulating layers may comprise a first organic insulating layer 141-1, a second organic insulating layer 141-2, a third organic insulating layer 141-3, and a fourth organic insulating layer 141-4.

The first organic insulating layer 141-1 may be disposed on the first inorganic insulating layer 135-1 in the green subpixel SPg, the second organic insulating layer 141-2 may be disposed on the second inorganic insulating layer 135-2 in the red subpixel SPr, and the third organic insulating layer 141-3 may be disposed on the third inorganic insulating layer 135-3 in the blue subpixel SPb.

The fourth organic insulating layer 141-4 may be disposed on the fourth inorganic insulating layer 135-4 formed on the entire region of the substrate 110.

The first organic insulating layer 141-1, the second organic insulating layer 141-2, and the third organic insulating layer 141-3 may be used as a color filter layer. In this instance, the first organic insulating layer 141-1, the second organic insulating layer 141-2, and the third organic insulating layer 141-3 may transmit only light of a specific wavelength band from light emitted from the red organic light-emitting element 120r, the green organic light-emitting element 120g, and the blue organic light-emitting element 120b, respectively.

The first organic insulating layer 141-1, the second organic insulating layer 141-2, and the third organic insulating layer 141-3 may be used as a photosensitive pattern. In this instance, there is no need to form a separate photosensitive pattern on the first organic insulating layer 141-1, the second organic insulating layer 141-2, and the third organic insulating layer 141-3.

The first organic insulating layer 141-1, the second organic insulating layer 141-2, and the third organic insulating layer 141-3 may be omitted, or the fourth organic insulating layer 141-4 may be omitted.

Meanwhile, a plurality of waterproof structures 143, 144-1 to 144-3 and 145-1 to 145-3 may be disposed in the second bank 111-2 positioned between a plurality of subpixels SPr, SPg, and SPb along the first direction X. A plurality of waterproof structures 143, 144-1 to 144-3 and 145-1 to 145-3 may be disposed in the second groove 131-2 of the second bank 111-2.

The plurality of waterproof structures may comprise the first waterproof structure 143, the second waterproof structures 144-1 to 144-3, the third waterproof structures 145-1 to 145-3, etc.

The plurality of waterproof structures, i.e., the first waterproof structure 143, the second waterproof structures 144-1 to 144-3, and the third waterproof structures 145-1 to 145-3, may be disposed in the second groove 131-2 of the second bank 111-2, so that the penetration of moisture, oxygen, etc. can be completely blocked.

The first waterproof structure 143 may be configured such that two or more inorganic insulating layers among the plurality of inorganic insulating layers 135-1 to 135-5 are overlapped on the second bank 111-2.

As illustrated in FIG. 2, the first inorganic insulating layer 135-1, the second inorganic insulating layer 135-2, and the third inorganic insulating layer 135-3 may be overlapped on the second groove 131-2 of the second bank 111-2, which is disposed between the red subpixel SPr and the green subpixel SPg, to form the first waterproof structure 143. For example, the second inorganic insulating layer 135-2 may be disposed on the first inorganic insulating layer 135-1, and the third inorganic insulating layer 135-3 may be disposed on the second inorganic insulating layer 135-2.

The third inorganic insulating layer 135-3, which is the uppermost layer, may be an island insulating pattern 135-3a. The island insulating pattern 135-3a may be a part of the third inorganic insulating layer 135-3 disposed on the blue cathode electrode 123b of the blue subpixel SPb, and may be spaced apart from the third inorganic insulating layer 135-3 disposed on the blue subpixel SPb. Since the island insulating pattern 135-3a is included in the first waterproof structure 143, the waterproof performance can be further improved.

The first organic insulating layer 141-1 may be disposed between the second inorganic insulating layer 135-2 and the first inorganic insulating layer 135-1, and the second organic insulating layer 141-2 may be disposed between the third inorganic insulating layer 135-3 and the second inorganic insulating layer 135-2. In this instance, the first organic insulating layer 141-1 and the second organic insulating layer 141-2 may each have a round surface. Accordingly, the second inorganic insulating layer 135-2 and the third inorganic insulating layer 135-3, which are disposed on the first organic insulating layer 141-1 and the second organic insulating layer 141-2, may each have a round surface.

The fourth organic insulating layer 141-4 may be a planarizing layer having a flat surface.

As illustrated in FIG. 3, the second inorganic insulating layer 135-2 and the third inorganic insulating layer 135-3 may be overlapped on the second groove 131-2 of the second bank 111-2, which is disposed between the blue subpixel SPb and the red subpixel SPr, so that the first waterproof structure 143 may be configured. The third inorganic insulating layer 135-3 may be disposed on the second inorganic insulating layer 135-2, and the second organic insulating layer 141-2 may be disposed between the third inorganic insulating layer 135-3 and the second inorganic insulating layer 135-2. Since the second organic insulating layer 141-2 has a round surface, the third inorganic insulating layer 135-3 on the second organic insulating layer 141-2 may have a round surface.

As illustrated in FIG. 4, the first inorganic insulating layer 135-1 and the third inorganic insulating layer 135-3 may be overlapped on the second groove 131-2 of the second bank 111-2 disposed between the green subpixel SPg and the blue subpixel SPb, so that the first waterproof structure 143 may be configured. The third inorganic insulating layer 135-3 may be disposed on the first inorganic insulating layer 135-1, and the first organic insulating layer 141-1 may be disposed between the third inorganic insulating layer 135-3 and the first inorganic insulating layer 135-1. Since the first organic insulating layer 141-1 has a round surface, the third inorganic insulating layer 135-3 on the first organic insulating layer 141-1 may have a round surface.

As illustrated in FIGS. 2 to 4, a plurality of second power wirings PL2 may be disposed under a plurality of second banks 111-2. The plurality of second power wirings PL2 may be exposed by a plurality of second grooves 131-2 of the plurality of second banks 111-2. A first waterproof structure 143 in which at least two or more inorganic insulating layers among the plurality of inorganic insulating layers 135-1 to 135-5 are overlapped may be positioned on a plurality of second power wiring PL2, respectively.

The second power wiring PL2 may be provided to prevent the interlayer-insulating layer 103 from being excessively etched when the interlayer-insulating layer 103 under the second bank 111-2 is removed to form the first undercut structure 151 and the second undercut structure 152. When there is no concern that the interlayer-insulating layer 103 will be excessively etched, the second power wiring PL2 may be omitted.

Meanwhile, the second waterproof structures 144-1 to 144-3 may be configured such that one inorganic insulating layer among the plurality of inorganic insulating layers 135-1 to 135-5 is formed in a curved shape by the first undercut structure 151. The third waterproofing structure 145-1 to 145-3 may be configured such that another inorganic insulating layer among the plurality of inorganic insulating layers 135-1 to 135-5 is formed in a curved shape by the second undercut structure 152.

The first undercut structure 151 and the second undercut structure 152 may be formed on a lower side of the second bank 111-2 that contacts the second groove 131-2 of the second bank 111-2. The first undercut structure 151 and the second undercut structure 152 may be formed by removing the interlayer-insulating layer 103 positioned on the lower side of the second bank 111-2 that contacts the second groove 131-2 of the second bank 111-2. That is, the side portion of the interlayer-insulating layer 103 may be recessed from the inner side portion of the second bank 111-2 in contact with the second groove 131-2 of the second bank 111-2 to a direction of an outer side, so that the first undercut structure 151 and the second undercut structure 152 may be formed.

As illustrated in FIG. 2, the first inorganic insulating layer 135-1 may be formed in a curved shape by the first undercut structure 151, so that the second waterproof structure 144-1 may be configured. The first inorganic insulating layer 135-1 may be disposed on the lower side of the second bank 111-2 and the side portion of the interlayer-insulating layer 103, which is in contact with the second groove 131-2 by the first undercut structure 151, so that the second waterproof structure 144-1 may be formed in a curved shape. Since the first inorganic insulating layer 135-1 may be formed in a curved shape, the penetration path of moisture, oxygen, etc. may be maximized, so that the waterproofing characteristics may be improved.

The second inorganic insulating layer 135-2 may be formed in a curved shape by the second undercut structure 152 of the second bank 111-2, so that the third waterproofing structure 145-1 may be configured. The second inorganic insulating layer 135-2 may be disposed on the lower side of the second bank 111-2 and the side portion of the interlayer-insulating layer 103, which contacts the second groove 131-2 by the second undercut structure 152, so that the third waterproofing structure 145-1 may be formed in a curved shape. Since the second inorganic insulating layer 135-2 may be formed in a curved shape, the penetration path of moisture, oxygen, etc. may be maximized, so that the waterproofing characteristics may be improved.

As illustrated in FIG. 3, the second inorganic insulating layer 135-2 may be formed in a curved shape by the first undercut structure 151 of the second bank 111-2, so that the second waterproof structure 144-2 may be configured. The second inorganic insulating layer 135-2 may be disposed on the lower side of the second bank 111-2 and the side portion of the interlayer-insulating layer 103, which contacts the second groove 131-2 by the first undercut structure 151, so that the second waterproof structure 144-2 may be formed in a curved shape. Since the second inorganic insulating layer 135-2 is formed in a curved shape, the penetration path of moisture, oxygen, etc. may be maximized, so that the waterproofing characteristics may be improved.

The third inorganic insulating layer 135-3 may be formed in a curved shape by the second undercut structure 152 of the second bank 111-2, so that the third waterproof structure 145-2 may be configured. The third inorganic insulating layer 135-3 may be disposed on the lower side of the second bank 111-2 and the side portion of the interlayer-insulating layer 103, which contacts the second groove 131-2 by the second undercut structure 152, so that the third waterproof structure 145-2 may be formed in a curved shape. Since the third inorganic insulating layer 135-3 is formed in a curved shape, the penetration path of moisture, oxygen, etc. may be maximized, so that the waterproofing characteristics may be improved.

As illustrated in FIG. 4, the third inorganic insulation layer 135-3 may be formed in a curved shape by the first undercut structure 151 of the second bank 111-2, so that the second waterproofing structure 144-3 may be configured. The third inorganic insulation layer 135-3 may be disposed on the lower side of the second bank 111-2 and the side portion of the interlayer-insulating layer 103, which contacts the second groove 131-2 by the first undercut structure 151, so that the second waterproofing structure 144-3 may be formed in a curved shape. Since the third inorganic insulation layer 135-3 may be formed in a curved shape, the penetration path of moisture, oxygen, etc. may be maximized, so that the waterproofing characteristics may be improved.

The first inorganic insulating layer 135-1 may be formed in a curved shape by the second undercut structure 152 of the second bank 111-2, so that the third waterproof structure 145-3 may be configured. The first inorganic insulating layer 135-1 may be disposed on the lower side of the second bank 111-2 and the side portion of the interlayer-insulating layer 103, which contacts the second groove 131-2 by the second undercut structure 152, so that the third waterproof structure 145-3 may be formed in a curved shape. Since the first inorganic insulating layer 135-1 is formed in a curved shape, the penetration path of moisture, oxygen, etc. may be maximized, so that the waterproofing characteristics may be improved.

According to the embodiment, since the connection structure 130 is disposed in the first groove 131-1 of the plurality of first banks 111-1 between the plurality of subpixels SPr, SPg and SPb having the same color along the second direction Y, the electrical connection between the cathode electrodes 123r, 123g and 123b of the plurality of subpixels SPr, SPg and SPb and the first power wiring PL1 is easy and a short-circuit defect can be prevented, so that the operation defect or the light emission defect of the subpixels SPr, SPg and SPb can be prevented, and the reliability can be improved. In particular, since the plurality of subpixels SPr, SPg and SPb on the second direction Y are grouped and the connection structure 130 is disposed between the grouped subpixels, the number of shots of the laser beam can be drastically reduced when using the laser ablation process to be described later, so that the process time or the process cost can be reduced.

According to the embodiment, a plurality of waterproof structures 143, 144-1 to 144-3 and 145-1 to 145-3 may be disposed in each of a plurality of second banks 111-2, so that moisture, oxygen, etc. penetrating along the second direction Y do not penetrate into the plurality of subpixels SPr, SPg, and SPb, thereby preventing malfunctions in operation or light emission of the subpixels SPr, SPg, and SPb, and improving reliability.

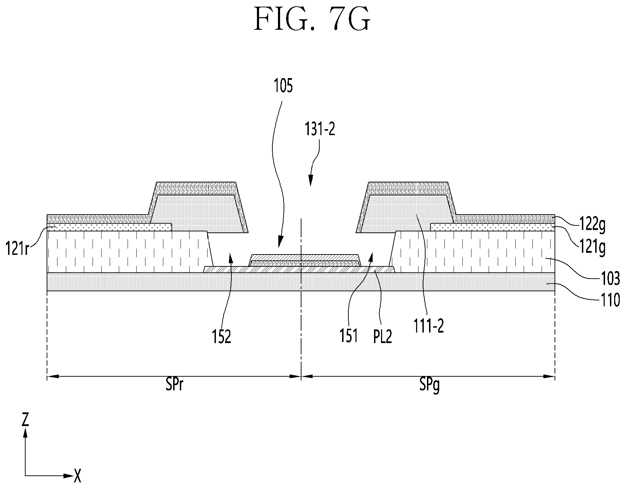

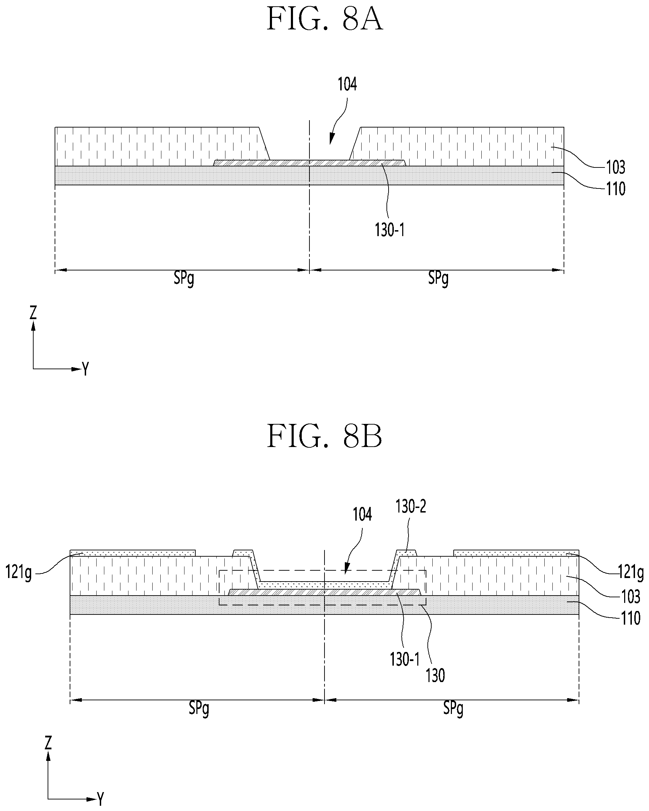

FIGS. 7A to 7R illustrate a manufacturing process of an organic light-emitting display device along line A-A' of FIG. 1. FIGS. 8A to 8R illustrate a manufacturing process of an organic light-emitting display device along line D-D' of FIG. 1.

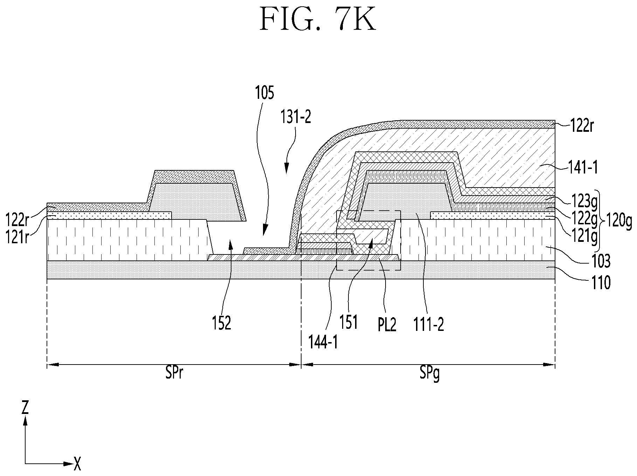

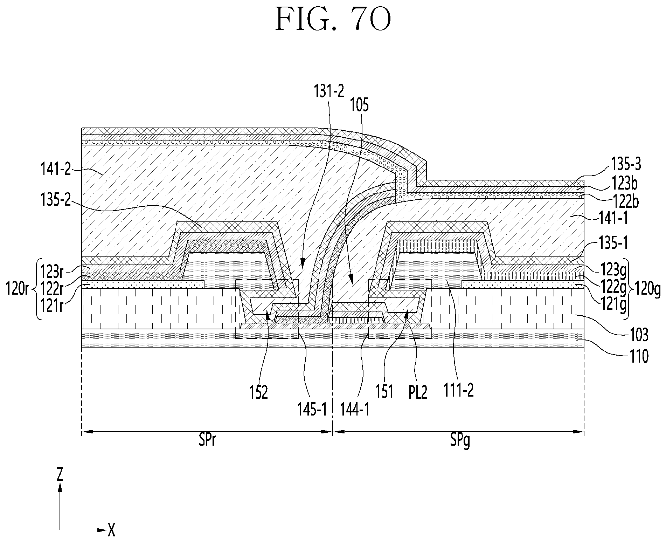

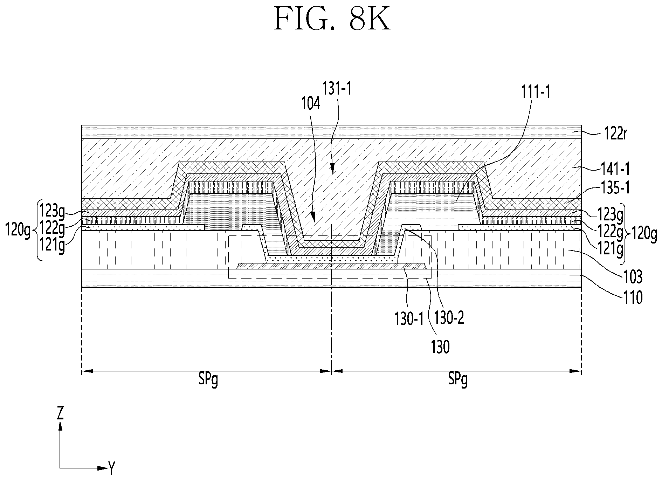

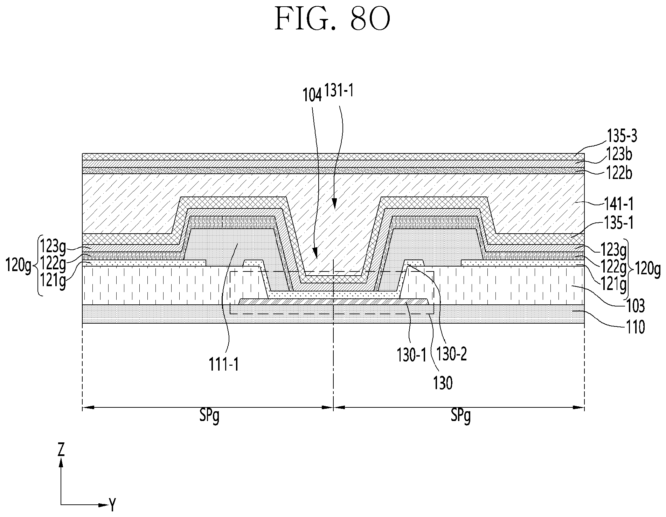

Although it is illustrated that the green organic light-emitting element 120g, the red organic light-emitting element 120r, and the blue organic light-emitting element 120b are manufactured in that order in FIGS. 7A to 7R and FIGS. 8A to 8R, the order may also be changed. For example, the green organic light-emitting element 120g may be manufactured (FIGS. 7A to 7J and FIGS. 8A to 8J), the red organic light-emitting element 120r may be manufactured (FIGS. 7K to 7N and FIGS. 8K to 8N), and the blue organic light-emitting element 120b may be manufactured (FIGS. 7O to 7Q and FIGS. 8O to 8Q).

As illustrated in FIGS. 7A and 8A, the driving circuit, the first power wiring PL1, the second power wiring PL2, the lower electrode 130-1, and the interlayer-insulating layer 103 may be formed on the substrate 110.

The substrate 110 may comprise a material having excellent insulation performance. For example, the substrate 110 may comprise a plastic material, a resin material, glass, etc. The substrate 110 may comprise a rigid material or a flexible material.

The driving circuit may comprise a plurality of transistors comprising a driving transistor, at least one or more capacitor, etc. The driving circuit may be formed on the substrate 110 by using a semiconductor process. Each of the plurality of transistors may comprise a gate electrode, a source electrode, and a drain electrode.

The first power wiring PL1, the second power wiring PL2, and the lower electrode 130-1 may be formed simultaneously with the same material as the source electrode and the drain electrode.

The interlayer-insulating layer 103 may be a single organic insulating layer or may comprise a plurality of insulating layers comprising an organic insulating layer and an inorganic insulating layer.

As illustrated in FIG. 8A, the interlayer-insulating layer 103 may be etched so that the lower electrode 130-1 may be exposed between a plurality of green subpixels SPg on the second direction Y. By etching the interlayer-insulating layer 103, a first groove 104 may be formed in the interlayer-insulating layer 103. Although not illustrated, the first groove 104 may be formed in the interlayer-insulating layer 103 between a plurality of red subpixels SPr on the second direction Y and between a plurality of blue subpixels SPb on the second direction Y.

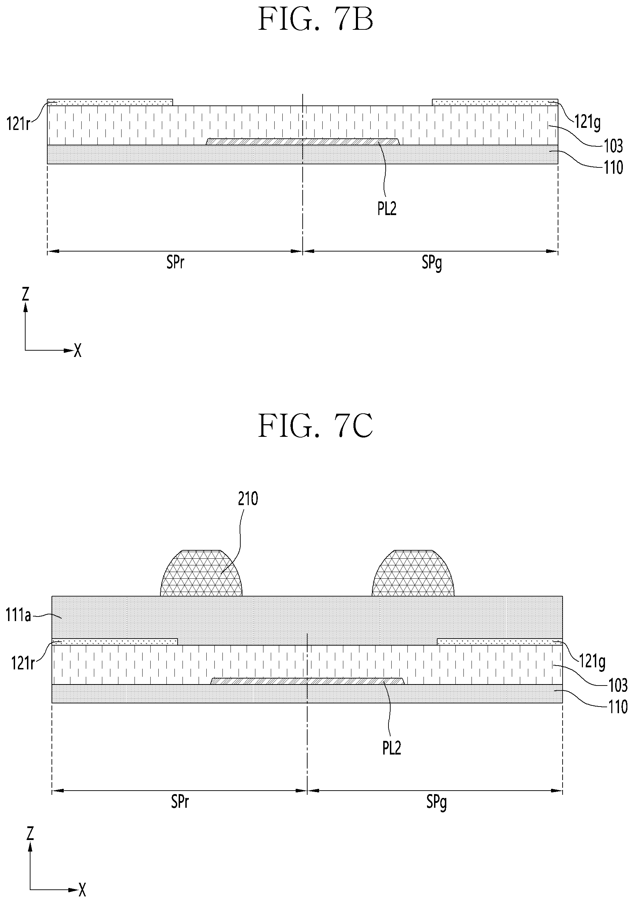

As illustrated in FIGS. 7B and 8B, a red anode electrode 121r, a green anode electrode 121g, an upper electrode 130-2, etc. may be formed on the interlayer-insulating layer 103.

The red anode electrode 121r may be formed in the red subpixel SPr, and the green anode electrode 121g may be formed in the green subpixel SPg. Although not illustrated, the blue anode electrode may be formed in the blue subpixel SPb.

The upper electrode 130-2 may be formed between adjacent green subpixels SPg, and may be formed spaced apart from the green anode electrode 121g formed in the green subpixel SPg. The upper electrode 130-2 may be in contact with an upper surface of the lower electrode 130-1 through the interlayer-insulating layer 103, so that a connection structure 130 may be formed. Although not illustrated, the connection structure 130 may also be formed between a plurality of red subpixels SPr in the second direction Y or between a plurality of blue subpixels SPb in the second direction Y.

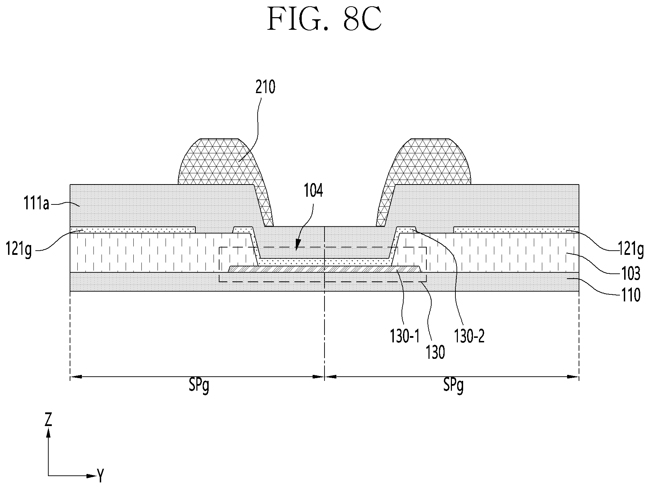

As illustrated in FIGS. 7C and 8C, at least one or more inorganic film 111a may be formed on the interlayer-insulating layer 103, and a photosensitive pattern 210 may be formed on the inorganic film 111a.

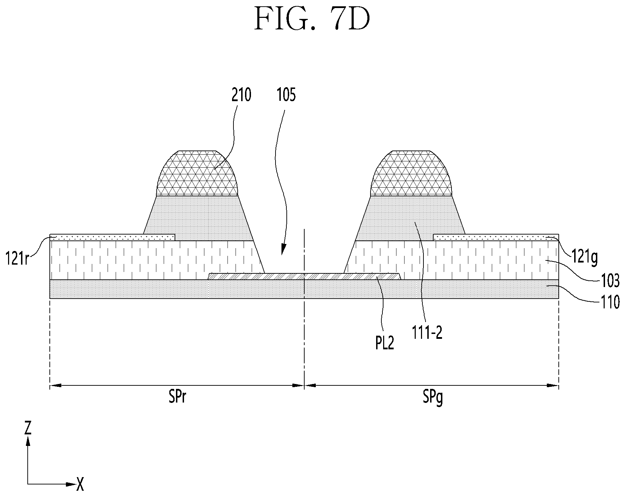

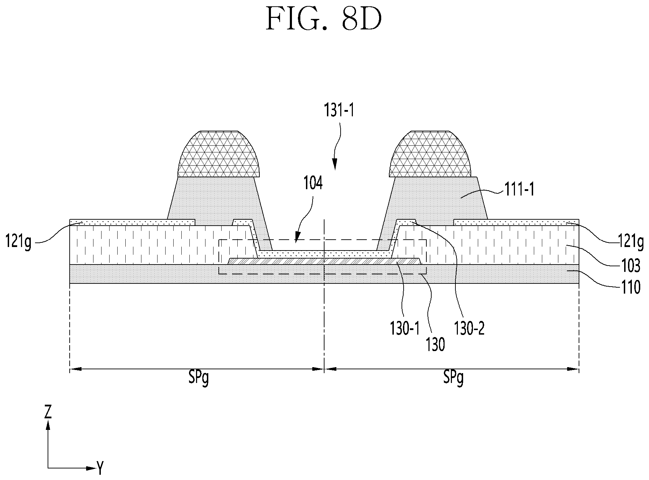

As illustrated in FIGS. 7D and 8D, a dry etching process may be performed using the photosensitive pattern 210, so that the inorganic film 111a may be removed.

By removing the inorganic film 111a, first grooves 104 and 131-1 may be formed between a plurality of green subpixels SPg in the second direction Y, and second grooves 105 and 131-2 may be formed between the red subpixel SPr and the green subpixel SPg. The upper electrode 130-2 of the connection structure 130 may be exposed by the first groove 104 and 131-1, and the second power wiring PL2 may be exposed by the second groove 105 and 131-2.

The first groove 104 and 131-1 may be locally formed only in the first bank 111-1 between adjacent green subpixels SPg along the second direction Y. The second grooves 105 and 131-2 may be formed lengthwise along the second direction Y between the red subpixel SPr and the green subpixel SPg.

An inner side portion of the second bank 111-2 and an inner side portion of the interlayer-insulating layer 103 contacting the second groove 105 and 131-2 may be positioned on the same vertical line or diagonal line.

Meanwhile, a wet etching process may be performed using the photosensitive pattern 210.

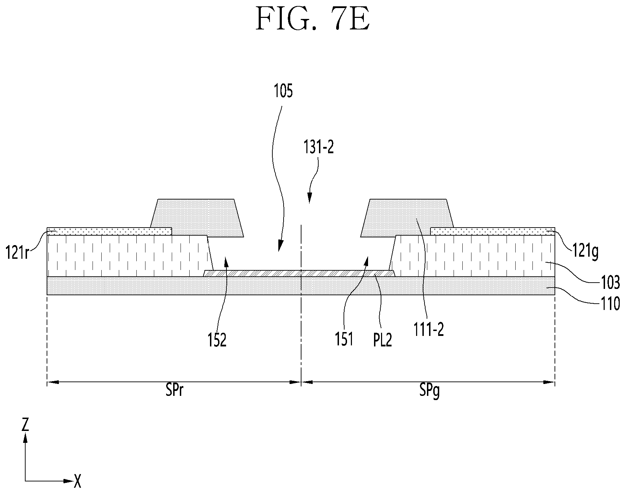

In this instance, as illustrated in FIG. 7E, the inner side portion of the interlayer-insulating layer 103 under the second bank 111-2 in contact with the second groove 105 and 131-2 may be additionally removed to form a first undercut structure 151 and a second undercut structure 152. For example, the first undercut structure 151 may be formed on the lower side of the second bank 111-2 adjacent to the green subpixel SPg, and the second undercut structure 152 may be formed on the lower side of the second bank 111-2 adjacent to the red subpixel SPr.

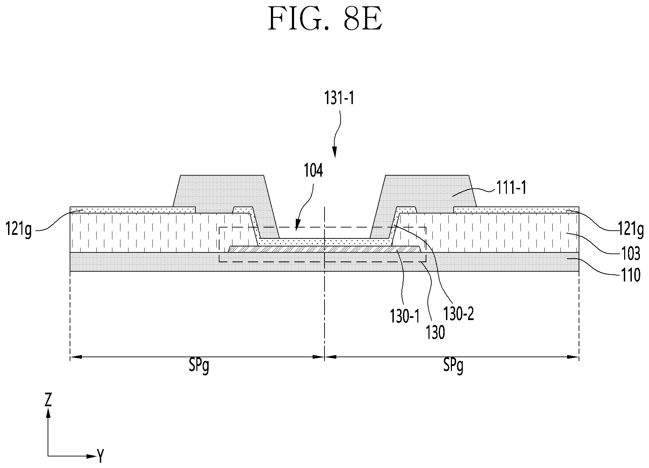

As illustrated in FIG. 8E, since the interlayer-insulating layer 103 is not exposed by the first groove 104 and 131-1 of the first bank 111-1, the interlayer-insulating layer 103 under the first bank 111-1 may not be removed while the inner side portion of the interlayer-insulating layer 103 under the second bank 111-2 is additionally removed.

Thereafter, the photosensitive pattern 210 may be removed.

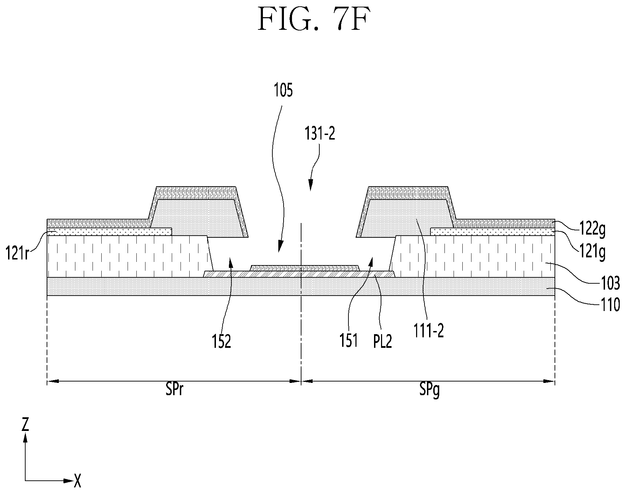

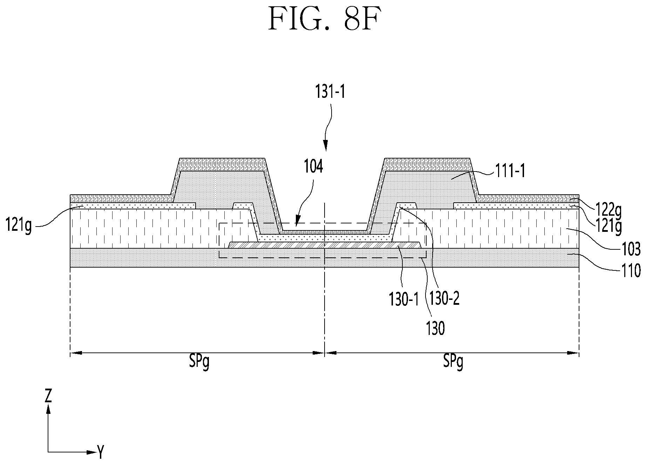

As illustrated in FIGS. 7F and 8F, the green organic light-emitting layer 122g may be deposited on the entire region of the substrate 110 or the display region AA of the substrate 110. The green organic light-emitting layer 122g may be deposited on the plurality of red subpixels SPr, the plurality of green subpixels SPg, the plurality of first banks 111-1, and the plurality of second banks 111-2. Although not illustrated, the green organic light-emitting layer 122g may be disposed on a plurality of blue subpixels SPb.

At least two stack structures may be formed by the green organic light-emitting layer 122g. The green organic light-emitting layer 122g may comprise a hole injection layer, a hole transport layer, an organic emission layer, an electron transport layer, an electron injection layer, a charge generation layer, etc.

As illustrated in FIG. 7F, the green organic light-emitting layer 122g deposited on the second power wiring PL2 and the green organic light-emitting layer 122g deposited on the upper side of the second bank 111-2 may be separated from each other by the first undercut structure 151 and the second undercut structure 152.

As illustrated in FIG. 8F, the green organic light-emitting layer 122g may be deposited on the upper electrode 130-2 of the first bank 111-1 and the adjacent green subpixel SPg so as to be connected to each other along the second direction Y.

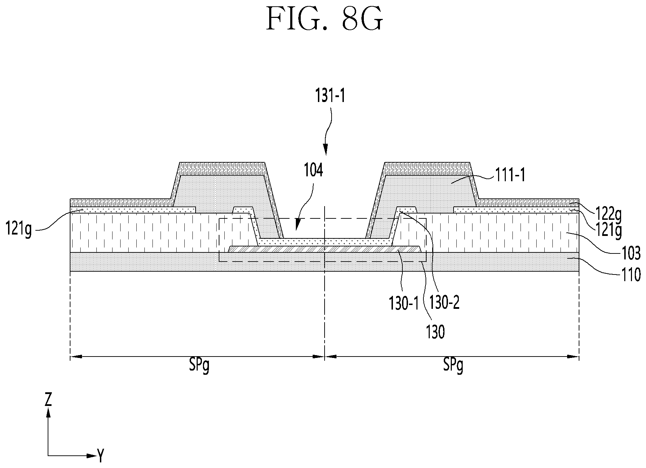

As illustrated in FIG. 8G, the green organic light-emitting layer 122g deposited on the upper electrode 130-2 of the connection structure 130 in the first groove 104 and 131-1 may be removed by using a laser ablation process. The laser ablation process may be, for example, a vacuum laser ablation process, but is not limited thereto.

Since the connection structure 130 is exposed using a laser ablation process, the laser beam may be irradiated only on the connection structure 130 among the entire region of the connection substrate 110.

The green organic light-emitting layer 122g may be heated, evaporated, or sublimated by the laser beam irradiated on the connection structure 130. Accordingly, the green organic light-emitting layer 122g on the upper electrode 130-2 may be removed, so that the upper electrode 130-2 of the connection electrode 130 can be exposed.

Since the laser beam is irradiated locally only on the corresponding upper electrode 130-2, a region of the green organic light-emitting layer 122g on the upper electrode 130-2 irradiated with the laser beam may be cleanly sublimated and removed.

The above-described connection structure 130 may solve the problem of the darkness of a center part of the panel even if more than 5 subpixels are connected per stripe pattern depending on the size of the product. A mobile product with a size of about 7~8" may not be equipped with the above-described connection structure 130. This is because the power may be electrically connected to a plurality of subpixels SPr, SPg, and SPb on the second direction Y in both regions of the stripe pattern on the second direction Y, for example, an upper bezel region and a lower bezel region. The electrical connection in the upper bezel region and the lower bezel region may be possible through an organic cell mask and/or an inorganic cell mask using a deposition process.

The above-described connection structure 130 may be necessary for products with a size of 8 to 9" or mor more to solve problems such as brightness reduction in a center part of the panel due to RC delay of the power supply as the screen gets larger.

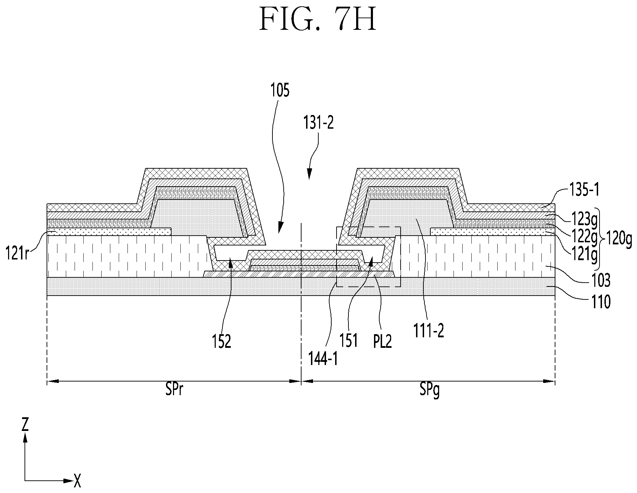

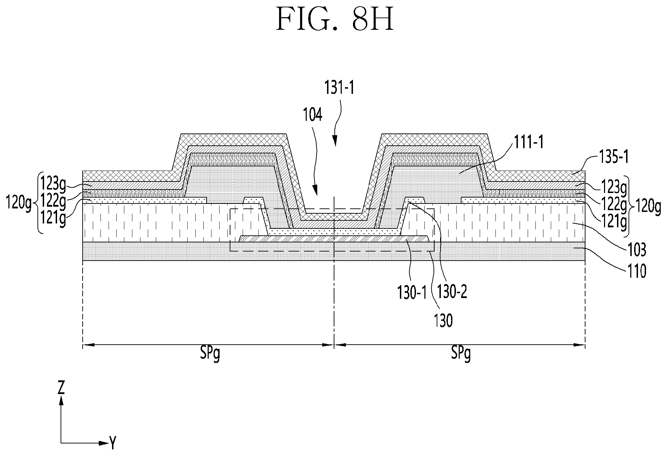

As illustrated in FIGS. 7H and 8H, the green cathode electrode 123g and the first inorganic insulating layer 135-1 may be formed on the entire region of the substrate 110 or the display region AA of the substrate 110. The first inorganic insulating layer 135-1 may be formed on the green cathode electrode 123g. The green cathode electrode 123g and the first inorganic insulating layer 135-1 may be formed on a plurality of red subpixels SPr, a plurality of green subpixels SPg, the first bank 111-1, and the second bank 111-2. Although not illustrated, the green cathode electrode 123g and the first inorganic insulating layer 135-1 may be formed on a plurality of blue subpixels SPb.

As illustrated in FIG. 7H, the green cathode electrode 123g deposited on the second power wiring PL2 and the green cathode electrode 123g deposited on the upper side of the second bank 111-2 may be separated from each other by the first undercut structure 151 and the second undercut structure 152. Alternatively, when the green cathode electrode 123g comprises a conductive layer such as ITO having excellent step coverage, the green cathode electrode 123g deposited on the second power wiring PL2 and the green cathode electrode 123g deposited on the upper side of the second bank 111-2 may be formed to be connected without a break.

As illustrated in FIG. 8H, the green cathode electrode 123g connected to the connection structure 130 may be formed to be connected to the adjacent green subpixel SPg via the upper side of the first bank 111-1. The green cathode electrode 123g of each of the plurality of green sub-pixels SPg on the second direction Y may be electrically connected to the first power wiring PL1 through the connection structure 130 by being in contact with the upper surface of the upper electrode 130-2 of the connection structure 130 in the first groove 104 and 131-1 of the first bank 111-1.

The first inorganic insulating layer 135-1 may be composed of a double layer comprising a silicon oxide layer and a silicon nitride layer on the silicon oxide layer. For example, the silicon oxide layer may be formed using an ALD process, and the silicon nitride layer may be formed using a CVD process.

When the first inorganic insulating layer 135-1 is formed of a double layer, the first inorganic insulating layer 135-1 may be formed without a break on the lower side of the second bank 111-2, the side portion of the interlayer-insulating layer 103, and the upper side of the second power wiring PL2 in the first undercut structure 151 and the second undercut structure 152. Accordingly, the second waterproof structures 144-1 to 144-3 may be formed by the first inorganic insulating layer 135-1 formed in the first undercut structure 151 and the second undercut structure 152. Since moisture, oxygen, etc. are blocked by the first inorganic insulating layer 135-1, they do not penetrate into the green organic light-emitting layer 122g or the green cathode electrode 123g through the lower side of the second bank 111-2 or the side portion of the interlayer insulating layer 103 in the first undercut structure 151 and the second undercut structure 152, so that the second waterproof structure 144-1 to 144-3 can enhance the performance of preventing penetration of moisture, oxygen, etc.

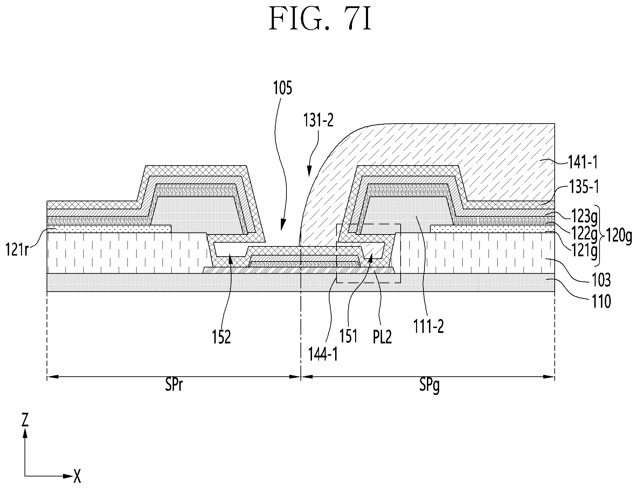

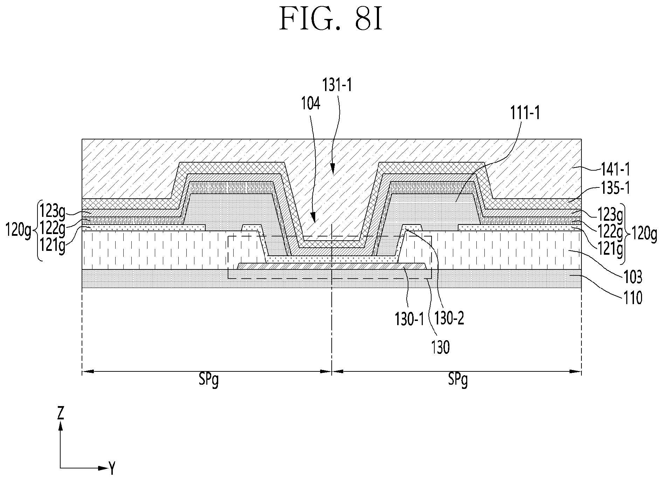

As illustrated in FIGS. 7I and 8I, the first organic insulating layer 141-1 may be formed on a plurality of green subpixels SPg in the second direction Y. In other words, the first organic insulating layer 141-1 may not be formed on a plurality of red subpixels SPr or a plurality of blue subpixels SPb in the second direction Y. The first organic insulating layer 141-1 may not be formed on the upper side of the second bank 111-2 adjacent to the red anode electrode 121r or the blue anode electrode 121b.

The first organic insulating layer 141-1 may be a color filter layer or a photosensitive pattern.

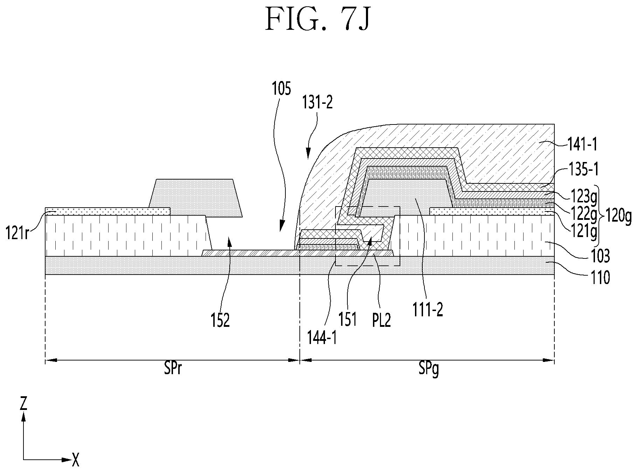

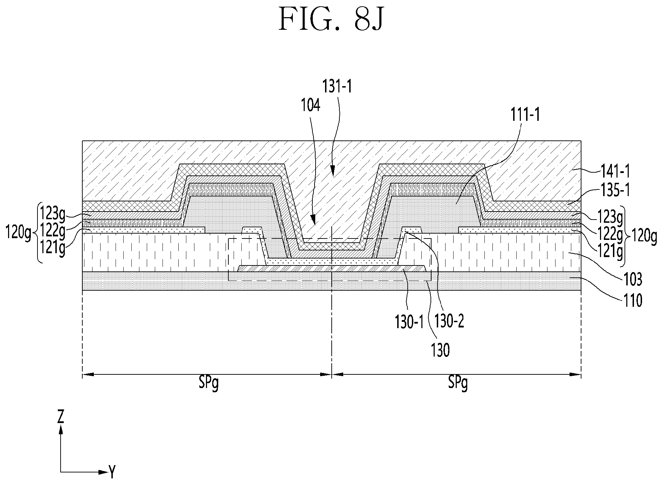

As illustrated in FIGS. 7J and 8J, an etching process may be performed to remove the remaining region except for the plurality of green subpixels SPg in the second direction Y, that is, the green organic light-emitting layer 122g, the green cathode electrode 123g, and the first inorganic insulating layer 135-1 formed in the plurality of red subpixels SPr and the plurality of blue subpixels SPb. Accordingly, a plurality of green organic light-emitting elements 120g may be formed in the plurality of green subpixels SPg in the second direction Y.

As illustrated in FIGS. 7K and 8K, the red organic light-emitting layer 122r may be deposited on the entire region of the substrate 110 or on the display region AA of the substrate 110.

As illustrated in FIG. 7K, the red organic light-emitting layer 122r may be deposited on the red anode electrode 121r in the red subpixel SPr. The red organic light-emitting layer 122r deposited on the upper side of the second bank 111-2 and the red organic light-emitting layer 122r deposited on the second power wiring PL2 in the second grooves 105 and 131-2 may be separated.

As illustrated in FIG. 8K, the red organic light-emitting layer 122r may be deposited on the first organic insulating layer 141-1 in the green subpixel SPg.

Although not illustrated, the red organic light-emitting layer 122r deposited on the connection structure 130 may be removed in the first groove 104 and 131-1 of the first bank 111-1 between the red subpixels SPr in the second direction Y by using a laser ablation process, so that the upper electrode 130-2 of the connection structure 130 may be exposed.

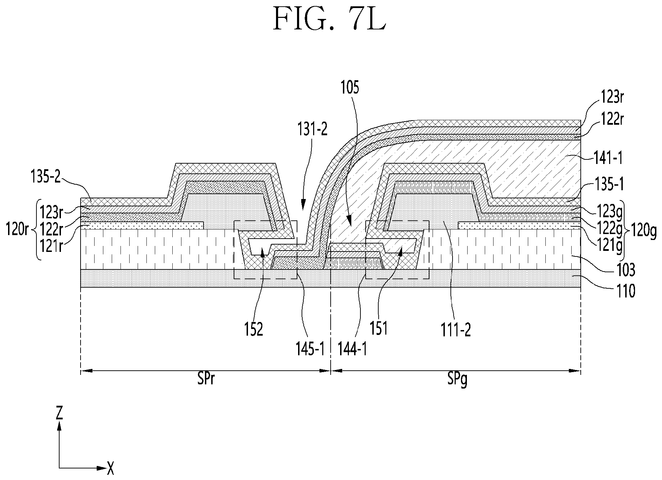

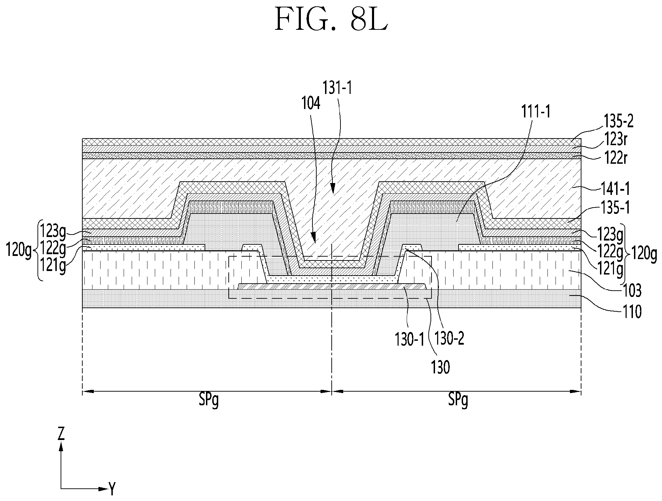

As illustrated in FIGS. 7L and 8L, the red cathode electrode 123r and the second inorganic insulating layer 135-2 may be formed on the entire region of the substrate 110 or on the display region AA of the substrate 110.

As illustrated in FIG. 7L, the red cathode electrode 123r may be deposited on the red organic light-emitting layer 122r in the red subpixel SPr. The red cathode electrode 123r deposited on the upper side of the second bank 111-2 and the red cathode electrode 123r deposited on the second power wiring PL2 in the second groove 105 and 131-2 may be separated.

Although not illustrated, the red cathode electrode 123r may be electrically connected to the connection structure 130 formed between the plurality of red subpixels SPr on the second direction Y. The red cathode electrode 123r of each of the plurality of red subpixels SPr on the second direction Y may be electrically connected to the first power wiring PL1 through the connection structure 130 by contacting the upper surface of the upper electrode 130-2 of the connection structure 130 with the red cathode electrode 123r.

As illustrated in FIG. 8L, the red cathode electrode 123r may be deposited on the red organic light-emitting layer 122r in the green subpixel SPg. Although not illustrated, the red cathode electrode 123r may be deposited on the red organic light-emitting layer 122r in the blue subpixel SPb.

The second inorganic insulating layer 135-2 may be composed of a double layer comprising a silicon oxide layer and a silicon nitride layer on the silicon oxide layer. For example, the silicon oxide layer may be formed using an ALD process, and the silicon nitride layer may be formed using a CVD process.

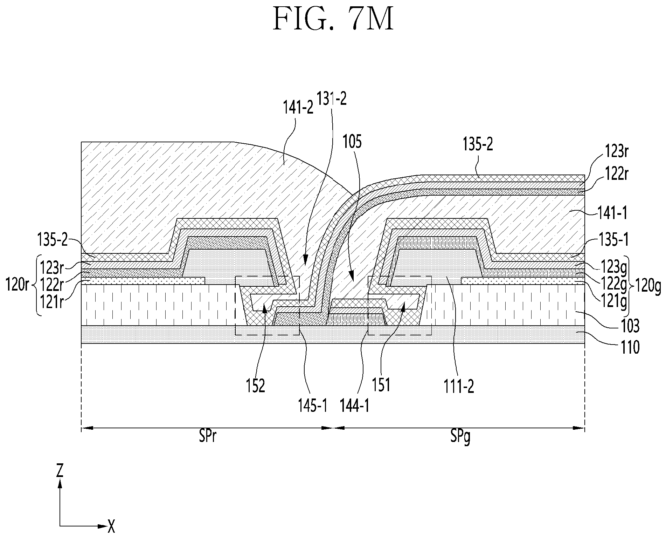

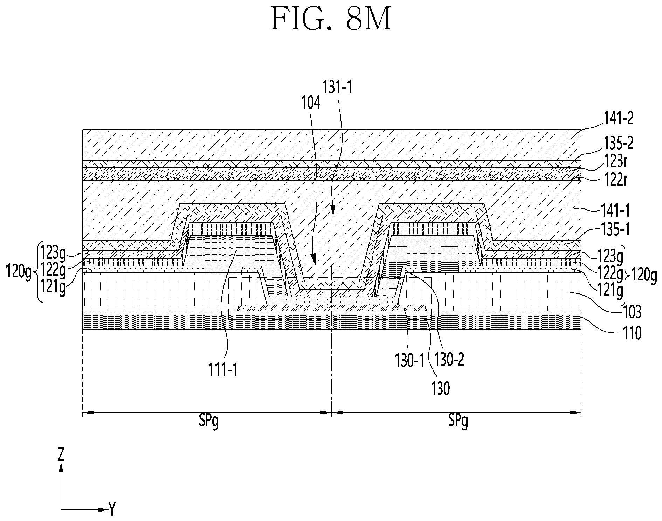

As illustrated in FIGS. 7M and 8M, the second organic insulating layer 141-2 may be formed on a plurality of red subpixels SPr in the second direction Y. In other words, the second organic insulating layer 141-2 may not be formed on a plurality of green subpixels SPg or a plurality of blue subpixels SPb in the second direction Y. The second organic insulating layer 141-2 may not be formed on the upper side of the second bank 111-2 adjacent to the green anode electrode 121g or the blue anode electrode 121b.

The second organic insulating layer 141-2 may be a color filter layer or a photosensitive pattern.

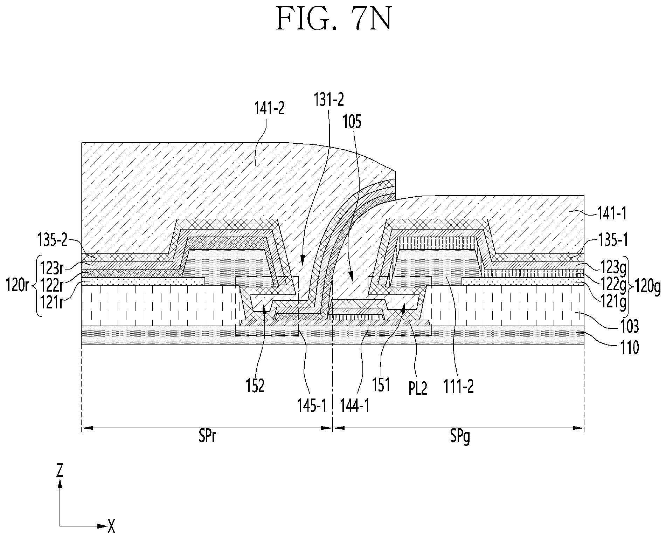

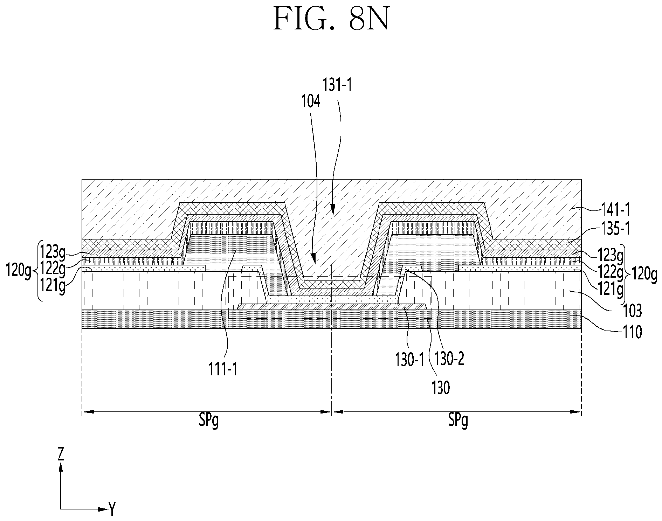

As illustrated in FIGS. 7N and 8N, an etching process may be performed to remove the remaining region except for the plurality of red subpixels SPr in the second direction Y, that is, the red organic light-emitting layer 122r, the red cathode electrode 123r, and the second inorganic insulating layer 135-2 formed in the plurality of green subpixels SPg and the plurality of blue subpixels SPb. Accordingly, a plurality of red organic light-emitting elements 120r may be formed in the plurality of red subpixels SPr in the second direction Y.

As illustrated in FIGS. 7O and 8O, a blue organic light-emitting layer 122b, a blue cathode electrode 123b, and a third inorganic insulating layer 135-3 may be formed on the entire region of the substrate 110 or on the display region AA of the substrate 110.

Although not illustrated, the blue cathode electrode 123b may be electrically connected to a connection structure 130 formed between a plurality of blue subpixels SPb on the second direction Y. The blue cathode electrode 123b of each of the plurality of blue subpixels SPb on the second direction Y may be electrically connected to the first power wiring PL1 through the connection structure 130 by contacting the upper surface of the upper electrode 130-2 of the connection structure 130.

The third inorganic insulating layer 135-3 may be composed of a double layer comprising a silicon oxide layer and a silicon nitride layer on the silicon oxide layer. For example, the silicon oxide layer may be formed using an ALD process, and the silicon nitride layer may be formed using a CVD process.

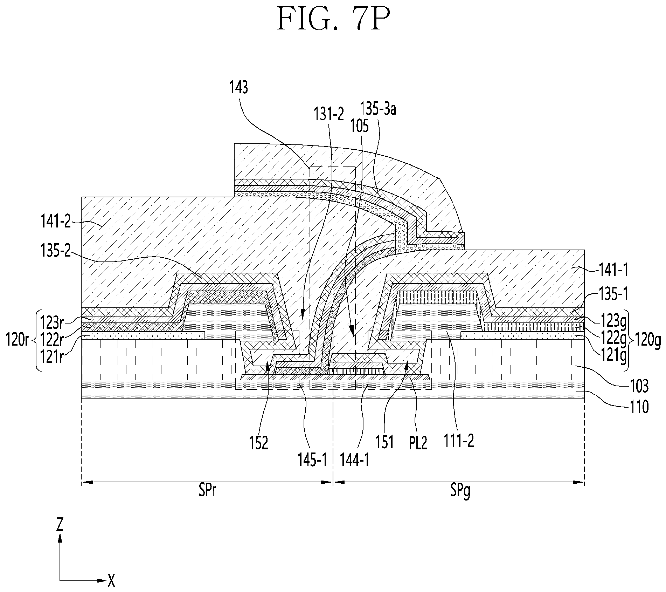

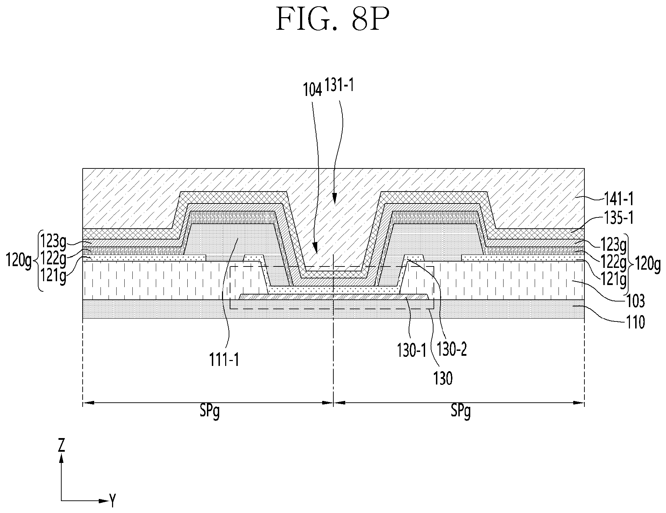

As illustrated in FIGS. 7P and 8P, the third organic insulating layer 141-3 may be formed on the plurality of blue subpixels SPb on the second direction Y. In other words, the third organic insulating layer 141-3 may not be formed on the plurality of red subpixels SPr or the plurality of green subpixels SPg on the second direction Y. The third organic insulating layer 141-3 may not be formed on the upper side of the second bank 111-2 adjacent to the red anode electrode 121r or the green anode electrode 121g.

The third organic insulating layer 141-3 may be a color filter layer or a photosensitive pattern.

An etching process may be performed to remove the remaining region except for the plurality of blue subpixels SPb on the second direction Y, that is, the blue organic light-emitting layer 122b, the blue cathode electrode 123b, and the third inorganic insulating layer 135-3 formed on the plurality of red subpixels SPr and the plurality of green subpixels SPg. Accordingly, a plurality of blue organic light-emitting elements 120b may be formed on the plurality of blue subpixels SPb on the second direction Y.

Meanwhile, as illustrated in FIG. 7P, at least one or more layer among the blue organic light-emitting layer 122b, the blue cathode electrode 123b, the third inorganic insulating layer 135-3, and the third organic insulating layer 141-3 may be formed on the second bank 111-2 between the red subpixel SPr and the green subpixel SPg. The third inorganic insulating layer 135-3 formed on the second bank 111-2 between the red subpixel SPr and the green subpixel SPg may be an island insulating pattern 135-3a. The island insulating pattern 135-3a may be formed on the second bank 111-2 between the red subpixel SPr and the green subpixel SPg, spaced apart from the third inorganic insulating layer 135-3 formed on the plurality of blue subpixels SPb.

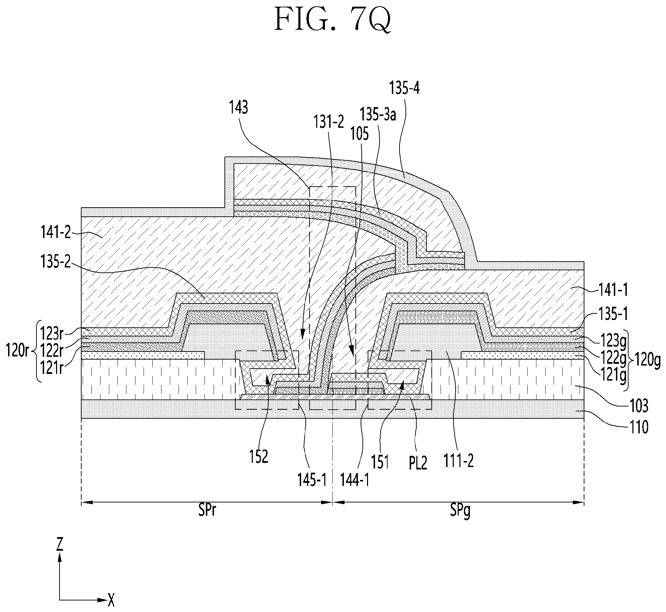

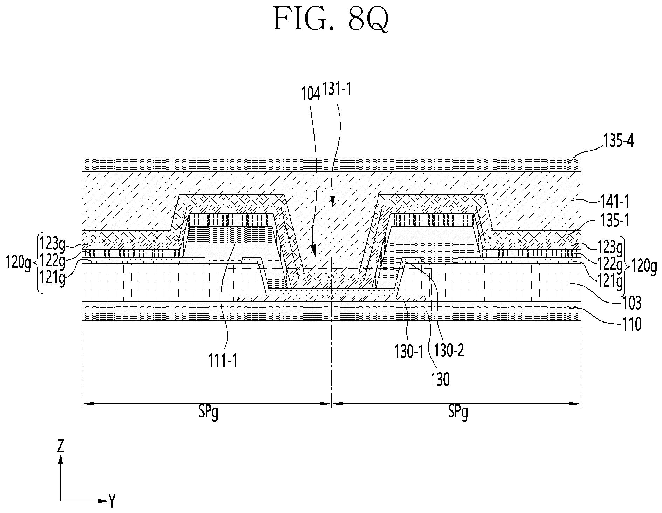

As illustrated in FIGS. 7Q and 8Q, the fourth inorganic insulating layer 135-4 may be formed on the entire region of the substrate 110 or on the display region AA of the substrate 110. The fourth inorganic insulating layer 135-4 may be formed using an inorganic material such as silicon nitride (SiNx) using a PECVD process, but is not limited thereto. The fourth inorganic insulating layer 135-4 may be omitted.

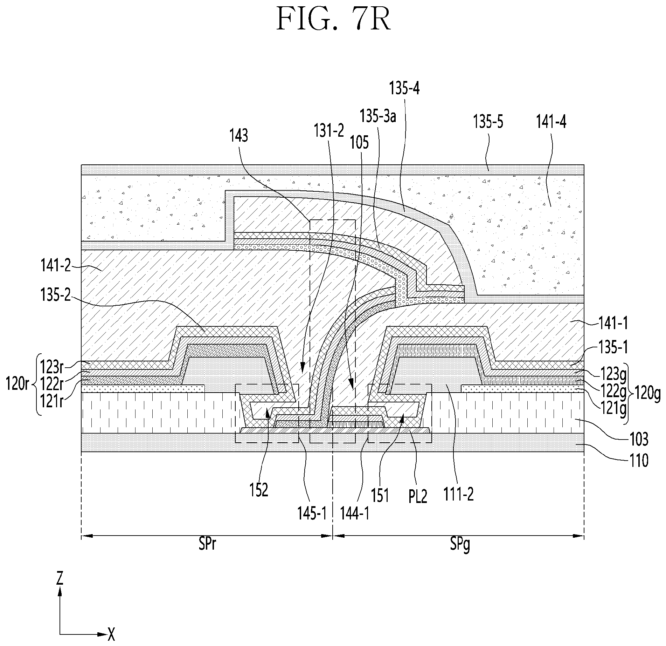

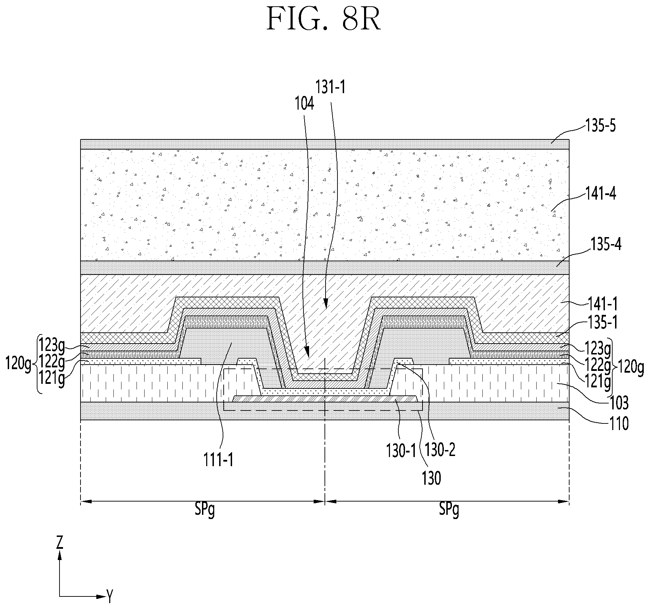

As illustrated in FIGS. 7R and 8R, the fourth organic insulating layer 141-4 and the fifth inorganic insulating layer 135-5 may be formed on the fourth inorganic insulating layer 135-4.

The fourth organic insulating layer 141-4 may be formed using an inkjet process, but is not limited thereto. The fifth inorganic insulating layer 135-5 may be formed of an inorganic material such as silicon nitride (SiNx) using a PECVD process, but is not limited thereto.

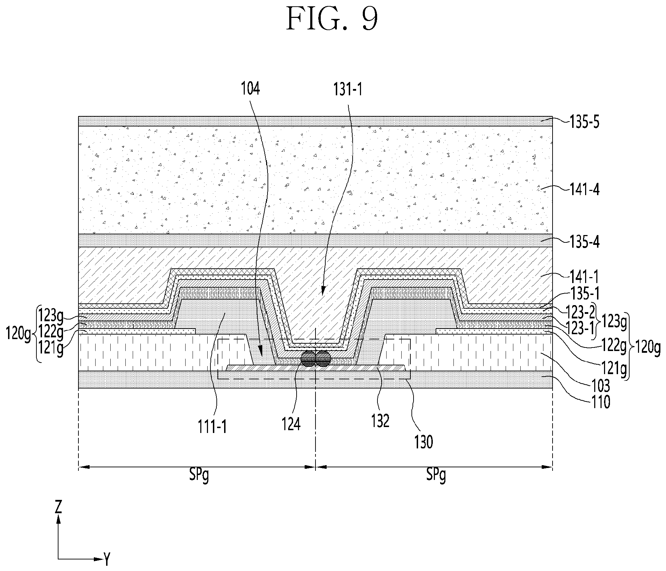

FIG. 9 is a cross-sectional view illustrating an organic light-emitting display device according to a sixth embodiment. Although FIG. 9 illustrates a green organic light-emitting element 120g, the organic light-emitting display device according to the sixth embodiment may be applied to a red organic light-emitting element 120r or a blue organic light-emitting element 120b in the same manner.

The sixth embodiment is identical to the fourth embodiment (FIG. 5) except for the connection structure 130. In the sixth embodiment, the same drawing reference numerals are given to components having the same shape, structure, and/or function as those of the fourth embodiment (FIG. 5), and detailed descriptions are omitted.

As illustrated in FIG. 9, the connection structure 130 may comprise an auxiliary electrode 132 and a connection part 124.

The auxiliary electrode 132 may extend from the first power wiring PL1. The auxiliary electrode 132 may be the same as the lower electrode 130-1 illustrated in FIG. 5, but is not limited thereto.

The connection part 124 may be disposed on the auxiliary electrode 132. The connection part 124 may be formed by penetrating the green organic light-emitting layer 122g.

The green cathode electrode 123g may be in contact with some regions of the auxiliary electrode 132 through the connection part 124. The green cathode electrode 123g may be in contact with some regions of the upper surface of the auxiliary electrode 132 through the connection part 124.

The connection part 124 may comprise the same material as the anode electrodes 121r, 121g, and 121b or the source electrode and drain electrode of the driving transistor. The source electrode and drain electrode of the driving transistor may be made of, for example, copper (Cu), aluminum (Al), titanium (Ti), or an alloy thereof.

As will be described later, the connection part 124 may be formed using a laser welding process. The laser welding process is not a vacuum-sublimation process like the vacuum ablation process described above, but rather allows mutual bonding through melting by instantaneous heating of the metal at atmospheric pressure. The atmosphere of the laser welding process may be a nitrogen (N2) atmosphere at atmospheric pressure or a clean room environment.

The upper side of the green cathode electrode 123g can be protected by at least an inorganic insulating film, so that mutual bonding may be performed without generating particles during the laser welding process. For example, when the green cathode electrode 123g is made of copper (Cu), the generation of whiskers may be induced. The whiskers refer to a phenomenon in which a metal single crystal naturally grows on a metal surface. For example, when the green cathode electrode 123g is made of aluminum (Al), it may induce the occurrence of hillock.

Meanwhile, silver (Ag) included in the green cathode electrode 123g and silver (Ag) included in the green anode electrode 121g may act as a medium for forming the connection 124.

Meanwhile, the green cathode electrode 123g may comprise a first conductive layer 123-1 and a second conductive layer 123-2. The second conductive layer 123-2 may be disposed on the first conductive layer 123-1.

The first conductive layer 123-1 may comprise a material having excellent electrical conductivity, such as Mg:Ag. The second conductive layer 123-2 may comprise a conductive oxide material having excellent step coverage, such as ITO.

The first conductive layer 123-1 comprising Mg:Ag, etc. may not have good step coverage. When the first conductive layer 123-1 is formed with a very thin thickness of approximately 10 nm, the step coverage may not be good, which may result in increased resistance or short circuiting. To solve this problem, the second conductive layer 123-2 comprising ITO, etc. which has excellent step coverage may be formed on the first conductive layer 123-1, thereby reducing resistance and preventing short-circuiting. That is, the second conductive layer 123-2 may be formed without a break on the first bank 111-1 between the plurality of green subpixels SPg and the plurality of green subpixels SPg along the second direction Y.

Meanwhile, after the red cathode electrode 123r comprising the first conductive layer 123-1 and the second conductive layer 123-2 is formed on the green organic light-emitting layer 122g, a laser welding process may be performed. In this instance, the green organic light-emitting layer 122g may be removed by the laser beam and the first conductive layer 123-1 may be melted. The melted first conductive layer 123-1 may be filled in a region where the green organic light-emitting layer 122g is removed, so that a connection part 124 may be formed. Accordingly, the connection part 124 may be formed of the same material as the first conductive layer 123-1.

Since the laser beam penetrates the second conductive layer 123-2, the second conductive layer 123-2 may be not melted by the laser beam. Even if the green organic light-emitting layer 122g is removed and the first conductive layer 123-1 is melted, the second conductive layer 123-2 may be stably electrically connected to the auxiliary electrode 132 through the connection part 124. In addition, the second conductive layer 123-2 may pass the laser beam and does not melt, so it can serve as a support for the connection structure 130.

Meanwhile, in the first to fifth embodiments (FIGS. 2 to 6), three laser ablation processes may be performed so that a plurality of connection structures 130 may be sequentially formed on the plurality of first banks 111-1 between the plurality of green subpixels SPg in the second direction Y, the plurality of first banks 111-1 between the plurality of red subpixels SPr in the second direction Y, and the plurality of first banks 111-1 between the plurality of blue subpixels SPb in the second direction Y. For example, after a plurality of green organic light-emitting elements 120g are formed on the plurality of green subpixels SPg, one laser ablation process may be performed so that a plurality of connection structures 130 may be formed on the first bank 111-1 between the plurality of green subpixels SPg in the second direction Y. Thereafter, after a plurality of red organic light-emitting elements 120r are formed in a plurality of red subpixels SPr, one laser ablation process may be performed to form a plurality of connection structures 130 on the first bank 111-1 between the plurality of red subpixels SPr in the second direction Y. Thereafter, after a plurality of blue organic light-emitting elements 120b are formed in a plurality of blue subpixels SPb, one laser ablation process may be performed to form a plurality of connection structures 130 on the first bank 111-1 between the plurality of blue subpixels SPb in the second direction Y.

In contrast, in the sixth embodiment (FIG. 9), only one laser welding process is performed, so that a plurality of connection structures 130 may be formed on a plurality of first banks 111-1 between a plurality of red subpixels SPr in the second direction Y, a plurality of first banks 111-1 between a plurality of green subpixels SPg in the second direction Y, and a plurality of first banks 111-1 between a plurality of blue subpixels SPb in the second direction Y. Accordingly, according to the sixth embodiment, since one laser welding process is performed, the process time and the manufacturing cost can be drastically reduced.

Meanwhile, according to the sixth embodiment, the laser welding process may be performed on the non-display region NAA of the substrate 110, so that a plurality of contact pads may be formed. The plurality of contact pads may be formed using one laser welding process together with the connection structure 130 formed on the display region AA. Accordingly, since a plurality of contact pads on the non-display region NAA and a plurality of connection structures 130 on the display region AA are simultaneously formed using one laser welding process, the process time and the manufacturing cost can be drastically reduced.

As illustrated in FIG. 1, the third power wiring PL3 connected to the power terminal 101 in the non-display region NAA and the first power wiring PL1 and the second power wiring PL2 formed in the display region AA may be formed on different layers. For example, the third power wiring PL3 connected to the power terminal 101 may be formed of the same material as the plurality of cathode electrodes 123r, 123g, and 123b.

In this instance, a contact pad may be formed to connect the third power wiring PL3 connected to the power terminal 101 with the first power wiring PL1 and the second power wiring PL2.

For example, the green organic light-emitting element 120g, the red organic light-emitting element 120r, and the blue organic light-emitting element 120b may be formed sequentially. In this instance, the cathode electrodes 123r, 123g and 123b of the green organic light-emitting element 120g, the red organic light-emitting element 120r and the blue organic light-emitting element 120b, respectively, may be disposed on the auxiliary electrode 132 extending from the first power wiring PL1 and/or the second power wiring PL2 in the display region AA, and the third power wiring PL3 connected to the power terminal 101 may be disposed on the first power wiring PL1 and/or the second power wiring PL2 in the non-display region NAA. Thereafter, a single laser welding process may be performed, and the plurality of cathode electrodes 123r, 123g, and 123b may be electrically connected to the auxiliary electrode 132 through the connection part 124 formed by melting the plurality of cathode electrodes 123r, 123g, and 123b in the display region AA, and the third power wiring PL3 connected to the power terminal 101 in the non-display region NAA may be electrically connected to the first power wiring PL1 and/or the second power wiring PL2.

According to the sixth embodiment, a plurality of connection structures 130 in the display region AA and a plurality of contact pads in the non-display region NAA may be simultaneously formed using a single laser welding process, so that the process time and the manufacturing cost can be drastically reduced.

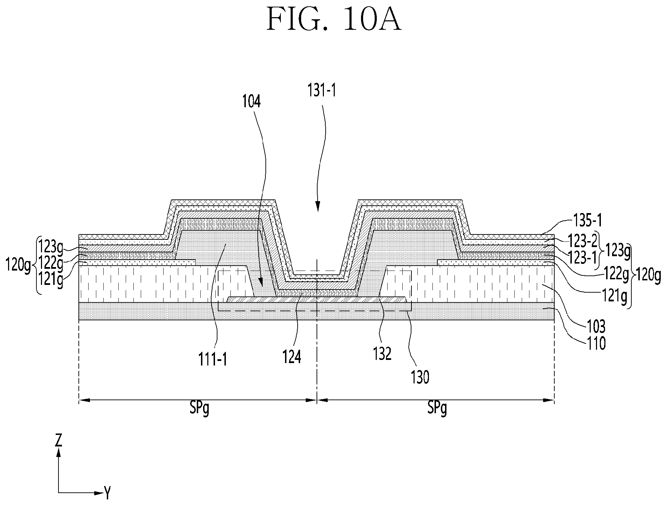

FIGS. 10A to 10C illustrate a manufacturing process of an organic light-emitting display device according to the sixth embodiment.

As illustrated in FIG. 10A, the green organic light-emitting layer 122g, the green cathode electrode 123g, and the first inorganic insulating layer 135-1 may be formed on the entire region of the substrate 110 or on the display region AA of the substrate 110.

As illustrated in FIGS. 8A to 8F, a series of processes may be performed so that the green organic light-emitting layer 122g may be deposited on the entire region of the substrate 110 or on the display region AA of the substrate 110. Thereafter, unlike the case where the laser ablation process is performed (FIG. 8G), the green cathode electrode 123g and the first inorganic insulating layer 135-1 may be formed on the entire region of the substrate 110 or on the display region AA of the substrate 110 without performing the laser ablation process (FIG. 10A).

Then, the remaining region except for the plurality of green subpixels SPg on the second direction Y, i.e., the green organic light-emitting layer 122g, the green cathode electrode 123g, and the first inorganic insulating layer 135-1 on the plurality of red subpixels SPr and the plurality of blue subpixels SPb, may be removed. Accordingly, the green organic light-emitting element 120g may be formed.

Although not illustrated, the red organic light-emitting element 120r, the second inorganic insulating layer 135-2, the blue organic light-emitting element 120b, and the third inorganic insulating layer 135-3 may be formed.

A first organic insulating layer 141-1, a second organic insulating layer 141-2, and a third organic insulating layer 141-3 may be formed on the first inorganic insulating layer 135-1, the second inorganic insulating layer 135-2, and the third inorganic insulating layer 135-3, respectively.

In the case of a pixel structure having a stripe pattern, a plurality of first power wirings PL1 may be electrically connected to the third power wiring PL3 in the non-display region NAA or the bezel region after the cathode electrodes 123r, 123g, and 123b are deposited and connected through a deposition process.

As described above, in a small panel of about 7 to 8", the first power wiring PL1 and the cathode electrodes 123r, 123g, and 123b may not be electrically connected in the display region AA. In a panel of 8" or larger, a laser welding process may be performed on connection structures 130 of 5 points or more per line of a stripe pattern to improve brightness reduction in a center part of the panel. For example, in a panel of 20" or larger, a laser welding process may be performed on connection structures 130 of 20 points or more per line of a stripe pattern.

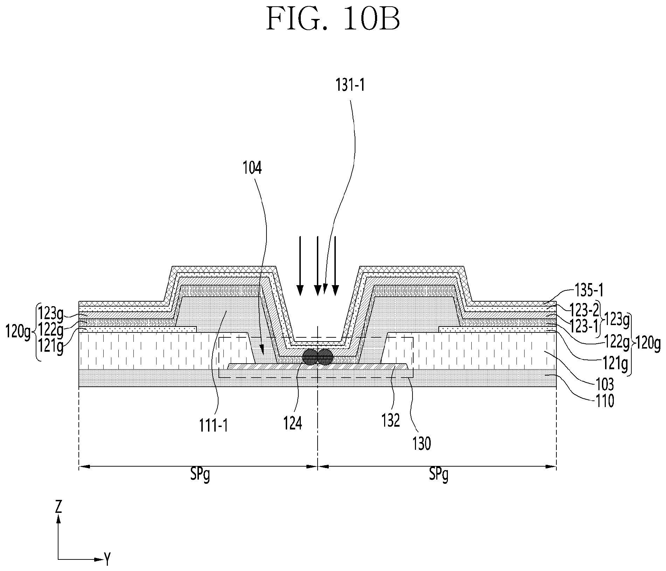

Thereafter, as illustrated in FIG. 10B, by performing one laser welding process, a plurality of connection structures 130 may be formed on a plurality of first banks 111-1 between a plurality of green subpixels SPg in the second direction Y, a plurality of first banks 111-1 between a plurality of red subpixels SPr in the second direction Y, and a plurality of first banks 111-1 between a plurality of blue subpixels SPb in the second direction Y. At the same time, the cathode electrodes 123r, 123g, and 123b of the red organic light-emitting element 120r, the green organic light-emitting element 120g, and the blue organic light-emitting element 120b, respectively, may be electrically connected to the connection structure 130.

Therefore, a plurality of connection structures 130 on the display region AA and a plurality of contact pads on the non-display region NAA may be simultaneously formed using a single laser welding process, thereby reducing the manufacturing time, dramatically increasing productivity, and reducing the manufacturing cost.

In addition, after a plurality of inorganic insulating layers 131-1 to 131-3 are formed, after a plurality of organic insulating layers 141-1 to 141-3 are formed, or after the fourth to fifth inorganic insulating layers 135-4 and 135-5 are formed, the laser welding process may be performed, but is not limited thereto.

Before the laser welding process is performed, the insulating layers 131-1 to 131-5 and 141-1 to 141-3 may be formed to prevent the penetration of moisture, oxygen, etc., so that the laser welding process can be performed in a normal pressure or clean room environment in a nitrogen (N2) atmosphere.

Therefore, the laser welding process can improve productivity and reduce investment costs compared to the laser ablation process. In addition, when a defect occurs during the image quality inspection process, repair is possible through laser welding, so that the laser welding process can contribute to improving yield and image quality.

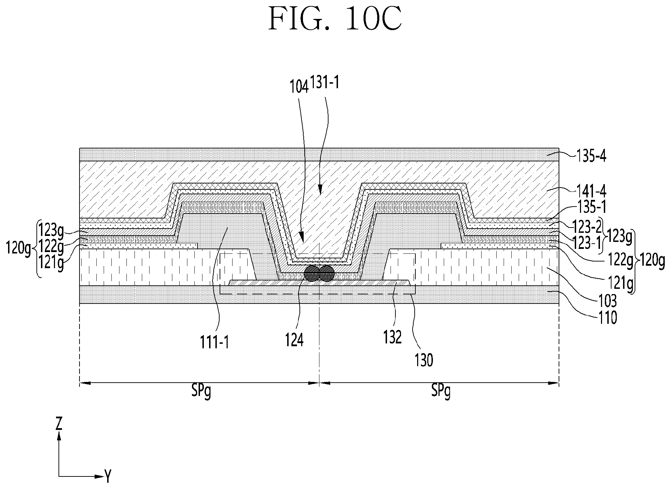

Thereafter, as illustrated in FIG. 10C, the fourth organic insulating layer 141-4 and the fifth inorganic insulating layer 135-5 may be formed on the entire region of the substrate 110 or on the display region AA of the substrate 110. The fifth inorganic insulating layer 135-5 may be formed on the fourth organic insulating layer 141-4.

Although not illustrated, after the fourth inorganic insulating layer (135-4 of FIG. 9) is formed, the fourth organic insulating layer 141-4 may be formed on the fourth inorganic insulating layer 135-4.

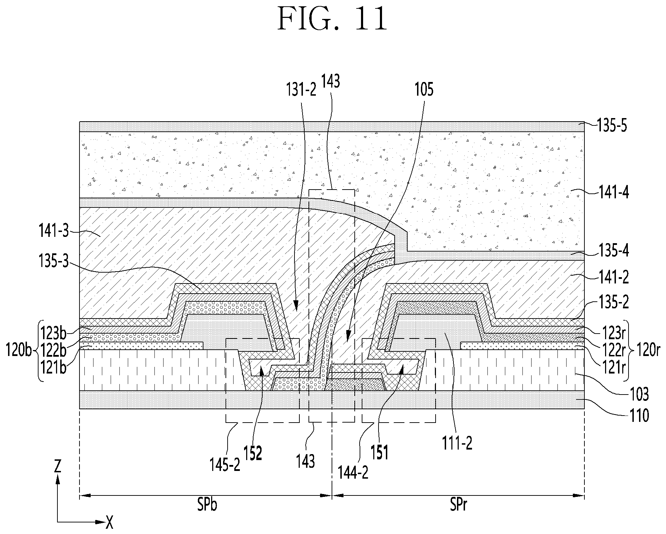

FIG. 11 is a cross-sectional view illustrating an organic light-emitting display device according to the seventh embodiment. The seventh embodiment (FIG. 11) may be the same as the second embodiment (FIG. 3) except that the second power wiring PL2 is omitted.

As illustrated in FIG. 1, the second power wiring PL2 may not be disposed along the second direction Y. As illustrated in FIG. 11, the second power wiring PL2 may not be disposed under the second bank 111-2 between the plurality of subpixels SPr, SPg, and SPb along the first direction X. In this instance, the red organic light-emitting layer 122r and the blue organic light-emitting layer 122b may be in direct contact with the upper surface of the substrate 110 in the second groove 131-2 of the second bank 111-2 or may be in contact with the upper surface of another layer on the substrate 110.

The second power wiring PL2 may be connected to the first power wiring PL1 by intersecting the first power wiring PL1, thereby allowing the first potential voltage supplied to the power terminal 101 to be smoothly and uniformly supplied to the plurality of subpixels SPr, SPg, and SPb. In addition, the second power wiring PL2 may be disposed in the second groove 131-2 of the second bank 111-2 to prevent the interlayer-insulating layer 103 from being excessively etched when the interlayer-insulating layer 103 is etched, as illustrated in FIG. 8A.

Even if the second power wiring PL2 is omitted, when there is no problem in supplying the first potential voltage and there is no concern that the interlayer-insulating layer 103 will be excessively etched, the second power wiring PL2 may not be disposed in the second groove 131-2 of the second bank 111-2.

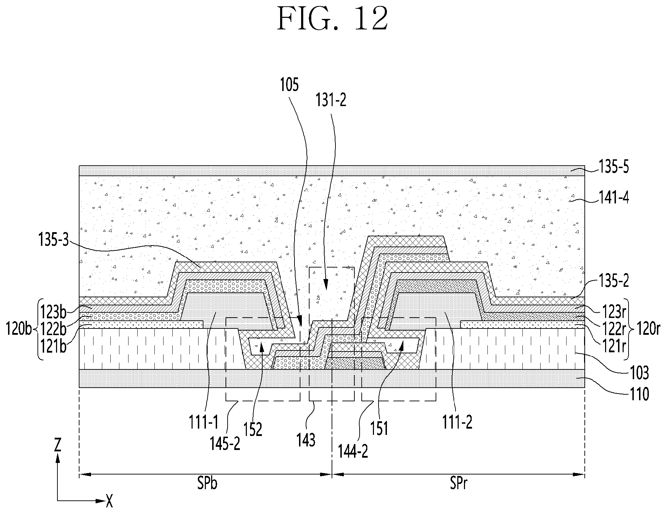

FIG. 12 is a cross-sectional view illustrating an organic light-emitting display device according to an eighth embodiment. The eighth embodiment (FIG. 12) may be the same as the second embodiment (FIG. 3) except that the second organic insulating layer 141-2 and the third organic insulating layer 141-3 are omitted.

As illustrated in FIG. 12, when the second organic insulating layer 141-2 and the third organic insulating layer 141-3 are not used as a color filter layer or a photosensitive pattern, the second organic insulating layer 141-2 and the third organic insulating layer 141-3 may be omitted.

For example, after a red organic light-emitting layer 122r, a red cathode electrode 123r, and a second inorganic insulating layer 135-2 are formed in the entire region of the substrate 110 or in the display region AA of the substrate 110, a second organic insulating layer 141-2 may be formed on a plurality of red subpixels SPr in the second direction Y. Since an etching process is performed using the second organic insulating layer 141-2 as a photosensitive pattern, the red organic light-emitting layer 122r, the red cathode electrode 123r, and the second inorganic insulating layer 135-2 on the plurality of green subpixels SPg and the plurality of blue subpixels SPb are removed, so that a plurality of red organic light-emitting elements 120r may be formed on the plurality of red subpixels SPr in the second direction Y.

Thereafter, the blue organic light-emitting layer 122b, the blue cathode electrode 123b, and the third inorganic insulating layer 135-3 are formed on the entire region of the substrate 110 or the display region AA of the substrate 110, and then the third organic insulating layer 141-3 may be formed on the plurality of blue subpixels SPb in the second direction Y. Since an etching process is performed using the third organic insulating layer 141-3 as a photosensitive pattern, the blue organic light-emitting layer 122b, the blue cathode electrode 123b, and the third inorganic insulating layer 135-3 on the plurality of red subpixels SPr and the plurality of green subpixels SPg are removed, so that a plurality of blue organic light-emitting elements 120b may be formed on the plurality of blue subpixels SPb in the second direction Y.

Although not illustrated, an etching process may be performed using the first organic insulating layer 141-1 as a photosensitive pattern, so that a plurality of green organic light-emitting elements 120g may be formed on the plurality of green subpixels SPg in the second direction Y.

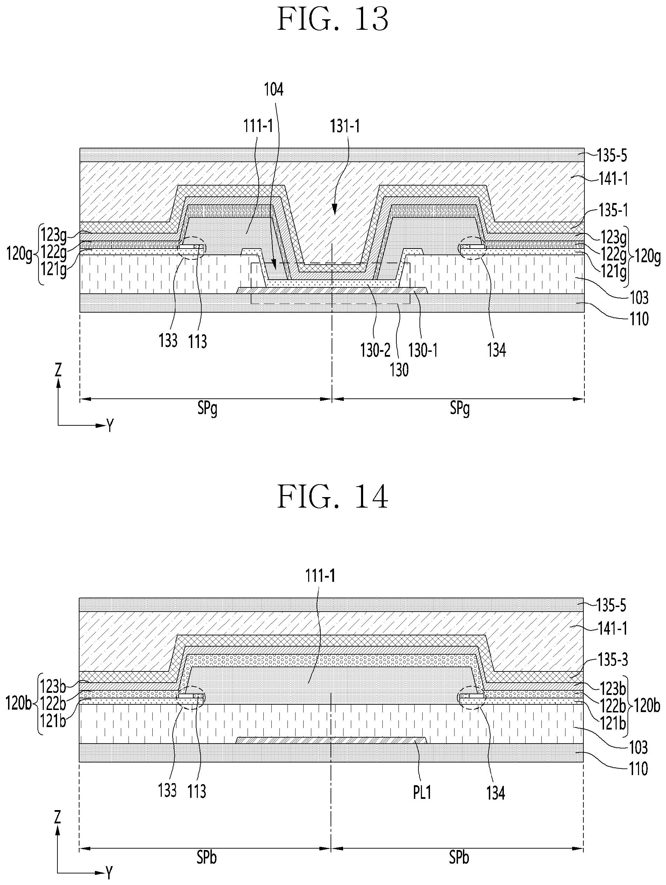

FIG. 13 is a cross-sectional view illustrating an organic light-emitting display device according to a ninth embodiment. FIG. 14 is a cross-sectional view illustrating an organic light-emitting display device according to a tenth embodiment.

The ninth embodiment (FIG. 13) and the tenth embodiment (FIG. 14) are similar to the fourth embodiment (FIG. 5) and the fifth embodiment (FIG. 6) except for the open structures 133 and 134, respectively. In the ninth embodiment (FIG. 13) and the tenth embodiment (FIG. 14), the same drawing reference numerals are given to components having the same shape, structure, and/or function as those of the fourth embodiment (FIG. 5) and the fifth embodiment (FIG. 6), and detailed descriptions are omitted.

As illustrated in FIG. 13, the open structures 133 and 134 may be formed in the edge region of the first bank 111-1 between the plurality of green subpixels SPg in the second direction Y. As illustrated in FIG. 14, the open structures 133 and 134 may be formed in the edge region of the first bank 111-1 between the plurality of blue subpixels SPb in the second direction Y. For example, the open structures 133 and 134 may be formed in the edge region of the lower side of the first bank 111-1, but are not limited thereto.

The open structure 133 and 134 may comprise at least one or more blocking layer 113 recessed inwardly from the side portion of the first bank 111-1. The first undercut structure 151 and the second undercut structure 152 may be formed in the edge region of the first bank 111-1 by the blocking layer 113. The blocking layer 113 may comprise a silicon-based inorganic material, a metal, etc. Aluminum (Al), molybdenum (Mo), a molybdenum alloy, etc. may be used as the metal, but is not limited thereto.

Meanwhile, since some organic light-emitting layers of the green organic light-emitting layer 122g and the blue organic light-emitting layer 122b, such as the hole injection layer and the charge generation layer, are made of low-resistance organic light-emitting materials, leakage current may easily flow through the hole injection layer, the charge generation layer, etc. When leakage current flows through the hole injection layer, the charge generation layer, etc., light may not be emitted from the green subpixel SPg or the luminance of the light can be significantly lower than the desired luminance due to an electrical short between the green anode electrode 121g and the green cathode electrode 123g.

Although not illustrated, since the red organic light-emitting layer 122r also comprises the hole injection layer, the charge generation layer, etc., the above-described problem may occur.

In the embodiment, since the hole injection layer, the charge generation layer, etc. corresponding to the open structures 133 and 134 are disconnected by the open structures 133 and 134, leakage current flowing to the hole injection layer, the charge generation layer, etc. may be blocked, so that poor image quality can be prevented.

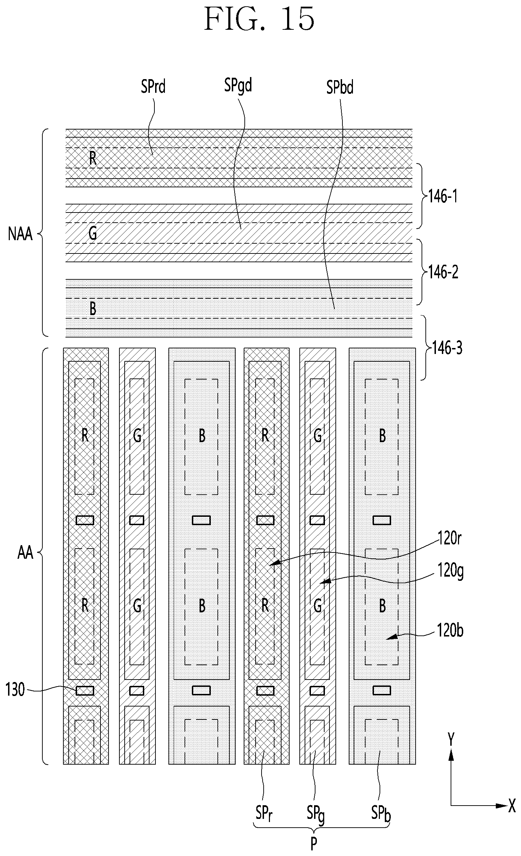

FIG. 15 is a plan view schematically illustrating an organic light-emitting display device according to a second embodiment.

As illustrated in FIG. 15, a plurality of subpixels SPr, SPg, and SPb may be arranged in a stripe shape along the second direction Y on the display region AA, and a plurality of dummy subpixels SPrd, SPgd, and SPbd may be arranged in a stripe shape along the first direction X on the non-display region NAA. The non-display region NAA may comprise a bezel region.

A plurality of waterproof structures 146-1 to 146-3 may be disposed between a plurality of dummy subpixels SPrd, SPgd, and SPbd on the second direction Y.

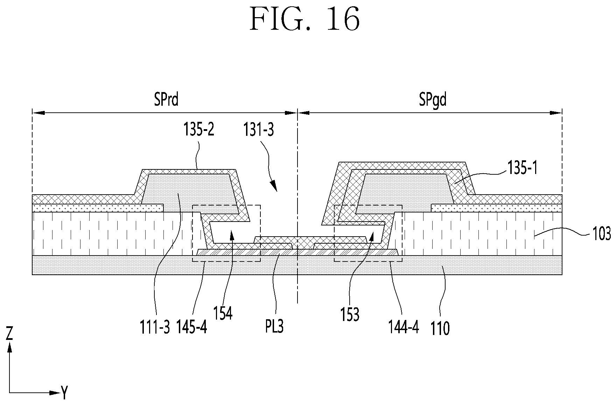

Meanwhile, since the non-display region NAA or the bezel region is a region where an image is not displayed, the red organic light-emitting element 120r, the green organic light-emitting element 120g, and the blue organic light-emitting element 120b may not be disposed. For example, as illustrated in FIG. 16, the red organic light-emitting element 120r may not be disposed in the red dummy subpixel SPrd, and the green organic light-emitting element 120g may not be disposed in the green dummy subpixel SPgd. That is, at least one or more of the anode electrode, the organic light-emitting layer, and the cathode electrode constituting the red organic light-emitting element 120r or the green organic light-emitting element 120g may not be disposed in the green dummy subpixel SPgd or the red dummy subpixel SPrd.

Although not illustrated, the blue organic light-emitting element 120b may not be disposed in the blue dummy subpixel SPbd.

A third bank 111-3 may be disposed between the red dummy subpixel SPrd and the red dummy subpixel SPrd, and a third groove 131-3 may be formed in the third bank 111-3. A plurality of undercut structures 153 and 154 may be formed on the lower side of the third bank 111-3 that contacts the third groove 131-3.

Each of the plurality of waterproof structures 146-1 to 146-3 may comprise two or more waterproof structures 144-4 and 145-4.

For example, the first waterproof structure 144-4 may be formed by a curved shape of the first inorganic insulating layer 135-1 disposed in the first undercut structure 153, and the second waterproof structure 145-4 may be formed by a curved shape of the second inorganic insulating layer 135-2 disposed in the second undercut structure 154.

The waterproof structures 144-4 and 145-4 may be the same as the second waterproof structures 144-1 to 144-3 and the third waterproof structures 145-1 to 145-3 illustrated in the first embodiment (FIG. 2) to the third embodiment (FIG. 4).

In this way, by forming a plurality of waterproof structures 146-1 to 146-3 between the plurality of dummy subpixels SPrd, SPgd, and SPbd on the non-display region NAA, moisture, oxygen, etc. can be blocked from penetrating into the display region AA from the non-display region NAA. Even if moisture, oxygen, etc. penetrate into the display region AA from the non-display region NAA, moisture, oxygen, etc. may be blocked by the plurality of waterproof structures (143, 144-1 to 144-3, 145-1 to 145-3 of FIGS. 2 to 4) formed lengthwise along the second direction Y between the plurality of subpixels SPr, SPg, and SPb in the first direction X in the display region AA, so that the moisture, oxygen, etc. may not penetrate into the plurality of organic light-emitting elements 120r, 120g, and 120b of the plurality of subpixels SPr, SPg, and SPb. Accordingly, the penetration blocking performance of moisture, oxygen, etc. can be dramatically improved, and the malfunction or light-emission failure of the subpixels SPr, SPg, and SPb can be prevented, thereby increasing reliability.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. An organic light-emitting display device, comprising:
a plurality of subpixels having different colors along a first direction and having the same color along a second direction crossing the first direction;
a plurality of anode electrodes in the plurality of subpixels;
a plurality of organic light-emitting layers on the plurality of anode electrodes;
a plurality of cathode electrodes on the plurality of organic light-emitting layers;
a plurality of first banks between the plurality of subpixels along the second direction;
a plurality of first power wirings along the first direction under the plurality of first banks; and
a plurality of connection structures disposed in a plurality of first grooves of some of the first banks among the plurality of first banks,
wherein the organic light-emitting layer and the cathode electrode are disposed across the some of the first banks, and
wherein the connection structure is configured to electrically connect the cathode electrode to the first power wiring in the first groove of the some of the first banks.

2. The organic light-emitting display device of claim 1, wherein the connection structure comprises:
a lower electrode extended from the first power wiring; and
an upper electrode on the lower electrode,
wherein the cathode electrode is in contact with an upper surface of the upper electrode.

3. The organic light-emitting display device of claim 2, wherein the upper electrode comprises the same material as the anode electrode.

4. The organic light-emitting display device of claim 1, wherein the connection structure comprises:
an auxiliary electrode extended from the first power wiring; and
a connection part penetrating the organic light-emitting layer on the auxiliary electrode,
wherein the cathode electrode is in contact with some regions of the auxiliary electrode through the connection part.

5. The organic light-emitting display device of claim 4, wherein the cathode electrode comprises:
a first conductive layer; and
a second conductive layer on the first conductive layer,
wherein the connection part comprises the same material as the first conductive layer.

6. The organic light-emitting display device of claim 1, further comprising:
an open structure in an edge region of the first bank,
wherein a hole injection layer or a charge generation layer of the organic light-emitting layer is disconnected by the open structure.

7. The organic light-emitting display device of claim 1, comprising:
a plurality of inorganic insulating layers on the plurality of cathode electrodes;
a plurality of second banks disposed lengthwise along the second direction between the plurality of subpixels in the first direction; and
a plurality of waterproof structures in each of the plurality of second banks.

8. The organic light-emitting display device of claim 7, wherein the plurality of waterproof structures comprises:
a first waterproof structure on the second bank;
a second waterproof structure on a first side of a second groove of the second bank; and
a third waterproof structure on a second side of the second groove of the second bank.

9. The organic light-emitting display device of claim 8, wherein the first waterproof structure is configured such that at least two or more inorganic insulating layers among the plurality of inorganic insulating layers are overlapped on the second bank.

10. The organic light-emitting display device of claim 9, wherein an uppermost layer among the at least two or more inorganic insulating layers is an island insulating pattern.

11. The organic light-emitting display device of claim 8, wherein the second waterproof structure is configured such that one inorganic insulating layer among the plurality of inorganic insulating layers is formed in a curved shape by a first undercut structure,
wherein the third waterproof structure is configured such that another inorganic insulating layer among the plurality of inorganic insulating layers is formed in a curved shape by a second undercut structure, and
wherein the first undercut structure and the second undercut structure are formed on a lower side of the second bank that contacts the second groove of the second bank.

12. The organic light-emitting display device of claim 11, further comprises:
a plurality of organic insulating layers on the plurality of inorganic insulating layers,
wherein one inorganic insulating layer among the plurality of inorganic insulating layers is disposed between two organic insulating layers among the plurality of organic insulating layers in the second groove.

13. The organic light-emitting display device of claim 12, wherein the one inorganic insulating layer has a round surface.

14. The organic light-emitting display device of claim 8, further comprising:
a plurality of second power wirings along the second direction in the plurality of second grooves of the plurality of second banks,
wherein the plurality of second power wirings are configured to be electrically connected to the plurality of first power wirings, and
wherein the at least two or more inorganic insulating layers are disposed on the second power wirings.

15. The organic light-emitting display device of claim 1, further comprising:
a plurality of dummy subpixels having a stripe shape along the first direction in a non-display region; and
a plurality of waterproof structures between the plurality of dummy subpixels in the second direction.
